(19) Europäisches Patentamt
European Patent Office
Office européen des brevets

(11) **EP 1 892 748 B1**

(12) **EUROPÄISCHE PATENTSCHRIFT**

(45) Veröffentlichungstag und Bekanntmachung des Hinweises auf die Patenterteilung:
**19.10.2011 Patentblatt 2011/42**

(51) Int Cl.:
*H01J 37/305* (2006.01)     *H01J 37/301* (2006.01)
*H01J 37/18* (2006.01)

(21) Anmeldenummer: **07022228.6**

(22) Anmeldetag: **25.02.2003**

(54) **Materialbearbeitungssystem und Materialbearbeitungsverfahren**

Material processing system and material processing method

Système de traitement de matériau et procédé de traitement de matériau

(84) Benannte Vertragsstaaten:
**CZ DE GB NL**

(30) Priorität: **25.02.2002 DE 10208043**

(43) Veröffentlichungstag der Anmeldung:
**27.02.2008 Patentblatt 2008/09**

(62) Dokumentnummer(n) der früheren Anmeldung(en) nach Art. 76 EPÜ:
**03742580.8 / 1 479 091**

(73) Patentinhaber:
• **Carl Zeiss NTS GmbH**
  **73447 Oberkochen (DE)**
• **Carl Zeiss SMS GmbH**
  **07745 Jena (DE)**

(72) Erfinder:
• **Koops, Hans, W., P.**
  **64372 Ober-Ramstadt (DE)**
• **Hoffrogge, Peter**
  **73447 Oberkochen (DE)**

(74) Vertreter: **Diehl & Partner GbR**
**Patentanwälte**
**Augustenstrasse 46**
**80333 München (DE)**

(56) Entgegenhaltungen:
EP-A- 0 106 510     WO-A-01/03145
US-A- 5 683 547     US-A- 6 042 738

## Beschreibung

Die Erfindung betrifft ein Materialbearbeitungssystem und ein Materialbearbeitungsverfahren , welche insbesondere in Verfahren zur Materialbearbeitung durch Materialabscheidung aus Gasen, wie etwa CVD (Chemical Vapor Deposition), oder Materialabtragung unter Zuführung von Reaktionsgasen einsetzbar sind. Hierbei wird insbesondere die Gasreaktion, welche zu einer Materialabscheidung oder zu einem Materialabtrag führt, durch einen Energiestrahl ausgelöst, der auf einen Bereich des zu bearbeitenden Werkstücks gerichtet ist.

Ein solches herkömmliches System ist aus US 5,055,696 bekannt. In diesem werden in eine Bearbeitungskammer, in der das zu bearbeitende Werkstück angeordnet ist, wahlweise mehrere Reaktionsgase eingeführt, und die Reaktion der Reaktionsgase mit dem Werkstück wird durch einen fokussierten Ionenstrahl oder Photonenstrahl ausgelöst. Die bearbeiteten Werkstücke umfassen integrierte Schaltkreise und Fotomasken zur Herstellung von integrierten Schaltkreisen.

Das bekannte System hat sich hinsichtlich der Genauigkeit, mit der die Werkstücke bearbeitbar sind, als unzulänglich erwiesen. Ebenso hat sich gezeigt, dass die in dem System eingesetzte Energiestrahlart und Gaszuführung einer Reduzierung der Dimensionen der kleinsten bearbeitbaren Strukturen bei dem System entgegenstehen.

US 5,148,024 offenbart ein Ionenstrahl-Bearbeitungsgerät und eine dazugehörige Gaskanone, US 5,435,850 offenbart ein Gas-Injektionssystem.

EP 0 106 510 offenbart ein Bearbeitungsgerät, etwa für einen Halbleiterwafer, mit einer Vorrichtung zur Erzeugung eines lokalisierten Vakuums.

Dokument WO/01/03145 offenbart eine Vorrichtung zur Untersuchung von Proben mit einem Strahl geladener Teilchen. Die Apparatur umfasst eine Gaszuführung zur Zuführung von Inertgas auf das Auftreffgebiet des Strahls an geladener Teilchen.

Dokument US 6 042 738 A offenbart Verfahren zur Anwendung eines fokussierten Teilchenstrahls zur Entfernung von Teilen einer Oberfläche und ferner zum gasunterstützten Ätzen.

Dokument US 5 683 547 A offenbart ein Bearbeitungsverfahren bei dem eine Oberfläche mit einem fokussierten Ionen- oder Elektronenstrahl in einer Atmosphäre aus Ätzgas bestrahlt wird.

Es ist eine Aufgabe der vorliegenden Erfindung, ein Materialbearbeitungssystem, ein Materialbearbeitungsverfahren und eine hierbei einsetzbare Gaszuführungsanordnung vorzuschlagen, mit welcher präzisere Arbeiten an dem zu bearbeitenden Werkstück durchführbar sind.

Diese Aufgabe wird gelöst durch den Gegenstand der unabhängigen Ansprüche. Vorteilhafte Ausführungsformen sind in den Unteransprüchen angegeben.

Ausführungs formen der Erfindung verwenden eine Gaszuführungsanordnung mit wenigstens einer Gaszuführung zum Zuführen eines Reaktionsgases zu einem Reaktionsort in einem Materialbearbeitungssystem. Das Reaktionsgas umfasst insbesondere ein sog. "Precursor-Gas", welches in der Nähe des Reaktionsorts durch einen Energiestrahl aktivierbar ist, um an dem Reaktionsort zu Materialabscheidung an dem zu bearbeitenden Werkstück oder zu einem Materialabtrag an dem Werkstück zu führen. Hierzu ist die Zuführung des Reaktionsgases gezielt zu steuern, d.h. ein Fluss des Reaktionsgases muss anschaltbar und abschaltbar sein. Hierzu umfasst die Gaszuführung ein Rohr mit einem ersten Innenquerschnitt, in welchem ein Ventilkörper zur Steuerung des Gasflusses zwischen einer ersten Stellung, in der er den Gasfluss freigibt, und einer zweiten Stellung, in der er den Gasfluss im wesentlichen versperrt, hin- und herverlagerbar ist. An das Rohr ist eine im Vergleich zu dem Rohr dünnere Kanüle gekoppelt, um das Reaktionsgas bis in die Nähe des Reaktionsortes zu transportieren.

Hierbei kann ein Volumen eines zusammenhängenden Gasraumes, der sich von dem Austrittsende der Kanüle bis zu dem Ventilkörper in dem Rohr erstreckt, wenn der Ventilkörper sich in seiner den Gasfluss versperrenden Stellung befindet, besonders klein sein. Dieses Volumen erfüllt dann insbesondere die Relation $V < c * A * 1$, wobei $A$ die Fläche des Innenquerschnitts der Kanüle an deren Austrittsende ist, $1$ ein Abstand zwischen dem Austrittsende der Kanüle und dem Ventilkörper in dessen den Gasfluss versperrenden Stellung ist und $c$ eine Konstante ist, die vorzugsweise kleiner als 5 ist.

Dieser Wahl des Volumens liegt folgende Überlegung zu Grunde: Wenn eine Reaktion des Reaktionsgases mit dem Werkstück bis zu einem gewünschten Ausmaß erfolgt ist, wird das Ventil geschlossen, um eine weitere Zuführung des Reaktionsgases zum Reaktionsort zu vermeiden. Es ist dann allerdings in dem Rohr- und Kanülenvolumen zwischen dem Ventilkörper in seiner geschlossenen Stellung und dem Austrittsende der Kanüle noch weiteres Reaktionsgas vorhanden, welches noch einige Zeit lang aus dem Austrittsende der Kanüle austritt und zu weiteren dann nachteiligen Ablagerungen des Reaktionsgases und zu weiteren Reaktionen desselben mit dem Werkstück führen kann.

Es wurde bereits vorgeschlagen, das Ventil besonders nahe an das Werkstück zu verlagern, um dieses Volumen des Gasraums zwischen Ventilkörper und Austrittsende möglichst zu reduzieren. Dann allerdings ist in der Nähe des Reaktionsortes auch Raum für die Anordnung des Ventils vorzusehen, was zu einem erhöhten Abstand zwischen der Werkstückoberfläche und einer Optik zum Richten des Energiestrahls auf das Werkstück führt. In manchen Anwendungen ist es allerdings wesentlich, einen solchen Abstand zu reduzieren, um einen fein fokussierten Energiestrahl zu erreichen.

Die Erfinder haben erkannt, dass ein solcher geringer Abstand zwischen der Optik und dem Werkstück dann realisierbar ist, wenn das Gas durch eine relativ dünne Kanüle in die Nähe des Reaktionsortes transportiert wird. In einer solchen dünnen Kanüle ist allerdings ein Ventil mit einem bewegbaren Ventilkörper nicht anord-enbar. Die Kanüle ist somit an das Rohr mit dem darin angeordneten verschiebbaren Ventilkörper gekoppelt, wobei das im Vergleich zur Kanüle wesentlich dikkere Rohr entfernt von dem Reaktionsort anordnenbar ist, wo dann ebenfalls der nötige Raum für den im Vergleich zu Kanüle großen Ventilkörper vorhanden ist.

Aufgrund dieser Überlegung ist also ein Gasvolumen zwischen dem Austrittsende der Kanüle und dem Ventilkörper nicht gänzlich zu vermeiden. Allerdings sieht die Erfindung vor, dieses Volumen möglichst klein auszugestalten, was bei Beachtung der oben angegebenen Relation möglich ist.

Vorzugsweise ist dieses Volumen noch kleiner gewählt, wobei dann insbesondere c < 3, weiterbevorzugt c < 1,5, insbesondere c < 1,2 und noch stärker bevorzugt c < 1,1 gilt. Es ist hierbei insbesondere möglich, eine Mehrzahl von verschiedenen Gaszuführungen um den Reaktionsort zu plazieren und für eine jede Gaszuführung eine vergleichsweise schnelle und zeitlich präzise Steuerung des Gasstroms durch Betätigen der jeweiligen Ventilkörper zu erreichen.

Gemäß einer besonders bevorzugten Ausgestaltung der Erfindung weist die Konstante c einen Wert von im wesentlichen gleich 1,0 auf, was beispielsweise dann erreichbar ist, wenn der Ventilkörper unmittelbar gegen eine dem Austrittsende der Kanüle entgegengesetzten Stirnende der Kanüle gedrückt wird, um den Gasfluss zu versperren.

Vorzugsweise hat die Kanüle einen Innendurchmesser von 0,3 mm bis 2,0 mm, weiter bevorzugt von 0,5 mm bis 1,7 mm und noch stärker bevorzugt 0,7 mm bis 1,5 mm. Entsprechend hat die Kanüle bevorzugt einen Außendurchmesser von 0,6 mm bis 2,5 mm, weiter bevorzugt von 0,8 mm bis 2,0 mm und noch stärker bevorzugt 1,0 mm bis 1,8 mm. Eine bevorzugte Länge der Kanüle liegt zwischen 30 mm und 70 mm und besonders bevorzugt zwischen 40 und 60 mm.

Weiterhin ist die Kanüle vorzugsweise derart ausgestaltet, dass ein Innenquerschnitt über eine Gesamtlänge der Kanüle im wesentlichen dem Innenquerschnitt der Austrittsöffnung der Kanüle entspricht, d.h. die Kanüle im Wesentlichen rohrförmig ausgestaltet ist. In einer weiteren, bevorzugten Ausgestaltung weist die Kanüle eine sich im Bereich der Austrittsöffnung verjüngende Form auf, d.h. der Innenquerschnitt im Bereich der Austrittsöffnung ist kleiner als ein Innenquerschnitt in einem Bereich zwischen dem sich verjüngenden Bereich der Austrittsöffnung und dem Eintrittsende, wobei der Grad der Verjüngung derart gewählt ist, dass die oben angegebenen Bedingungen an das Volumen bzw. die Konstante c erfüllt sind. Um ein unerwünschtes Nachströmen von Reaktionsgas zu verhindern, ist es nämlich vorteilhaft, eine sich nur leicht bzw. nicht verjüngende Kanüle einzusetzen, welche einen Rückstau von Gas durch einen im Verhältnis zur Gesamtkanüle kleinen Innenquerschnitt der Austrittsöffnung verhindert.

Weitere Aus führungsformen der Erfindung verwenden eine Gaszuführungsanordnung mit wenigstens einer Gaszuführung, welche einen in einem Rohr verschiebbaren Ventilkörper aufweist, der zwischen einer ersten Stellung, in der er einen Gasfluss aus dem Rohr heraus freigibt, und einer zweiten Stellung, in der er einen Gasfluss aus dem Rohr heraus im wesentlichen versperrt, verlagerbar ist. In einer bevorzugten Ausgestaltung weist der Ventilkörper einen quadratischen Querschnitt mit abgerundeten Ecken auf, so dass der Ventilkörper mit seinen abgerundeten Ecken an einem Innenmantel des Rohrs geführt ist, während zwischen einem jeden Paar von abgerundeten Ecken ein Bereich des Ventilkörpers einen vergrößerten Abstand von dem Innenmantel des Rohrs aufweist, um vier Durchtrittsquerschnitte bereitzustellen, durch welche Reaktionsgas den Ventilkörper im Inneren des Rohrs umfließen und dann in der von dem Dichtring entfernten Stellung des Ventilkörpers in die Kanüle eintreten kann. Ferner ist ein Reservoir zur Aufnahme eines festen oder/und flüssigen Ausgangsmaterials zur Bereitstellung des Reaktionsgases vorgesehen. Das Reaktionsgas entsteht durch Verdampfung, Verdunstung oder Sublimation des flüssigen bzw. festen Ausgangsmaterials.

hierbei ist eine Temperierungsvorrichtung zum Einstellen einer Temperatur des Ausgangsmaterials vorgesehen.

Diese Ausgestaltung des Reservoirs ist insbesondere in Kombination mit einem Zwei-Stellungs-Ventil vorteilhaft, welches im Unterschied zu einem Dosierventil lediglich eine im wesentlichen vollständig verschlossene und eine im wesentlichen vollständig geöffnete Stellung aufweist. Es lässt sich dann nämlich der Strom des Reaktionsgases hin zu dem Reaktionsort durch das Einstellen der Temperatur des Ausgangsmaterials dosieren, da der Dampfdruck des Ausgangsmaterials temperaturabhängig ist.

Vorzugsweise werden hierbei Ausgangsmaterialien ausgewählt, welche bei einer Temperatur, die unterhalb einer Raumtemperatur liegt, einen ausreichenden Dampfdruck aufweisen, um einen Gasfluss von dem Reservoir durch das Ventil hin zum Probenort bereitzustellen. Die Temperierungsvorrichtung umfasst dann vorzugsweise eine Kühlvorrichtung, um für das Ausgangsmaterial die Temperatur unterhalb der Raumtemperatur einzustellen, bei der der Dampfdruck des Ausgangsmaterials eine gewünschte Größe aufweist. Beispiele für derartige Ausgangsmaterialien sind: Pentabutylsilan oder Tetrabutylsilan und Wasserstoffperoxid, welche zusammen einsetzbar sind, um Siliziumdioxid an dem Werkstück abzuscheiden, sowie Cyclopentadienyl-Trimethyl-Platin, mit welchem ein Platin-Kohlenstoff-Verbundwerkstoff auf dem Werkstück abscheidbar ist.

Indem das Reservoir mit dem Ausgangsmaterial auf einer Temperatur gehalten ist, die unterhalb der Temperatur der übrigen Komponenten der Gaszuführungsanordnung liegt, ist weitgehend sichergestellt, dass sich das aus dem Reservoir austretende Reaktionsgas nicht an Wandungen der übrigen Komponenten der Gaszuführungsanordnung niederschlägt.

Alternativ oder ergänzend zu einer Kühlung des Ausgangsmaterials ist vorzugsweise ebenfalls vorgesehen, andere Komponenten der Gaszuführungsanordnung, wie etwa die Kanüle oder den Ventilkörper oder das Rohr, in dem der Ventilkörper verschiebbar gelagert ist, zu heizen.

Um den Dampfdruck des Ausgangsmaterials in dem Reservoir mit erhöhter Genauigkeit auf einen gewünschten Wert einzustellen, ist vorzugsweise ein Drucksensor zur Messung dieses Gasdrucks sowie eine Steuerung vorgesehen, welche in Abhängigkeit von einem von dem Drucksensor bereitgestellten Druckmesssignal die Temperierungsvorrichtung ansteuert, um die Temperatur des Ausgangsmaterials in dem Reservoir zu ändern. Der Drucksensor ist vorzugsweise an einen Gasraum gekoppelt, welcher das Reservoir, das Rohr, in dem der Ventilkörper verschiebbar ist, und Verbindungsleitungen hierzwischen umfasst.

Weifere Ausführungs formen der Erfindung verwenden eine Gaszuführungsanordnung, welche wenigstens zwei Gaszuführungen umfasst, um zwei verschiedene Reaktionsgase an den Reaktionsort zu führen. Entsprechend sind in den Reservoiren der wenigstens zwei Gaszuführungen verschiedene Ausgangsmaterialien enthalten, welche bei ihren Arbeitstemperaturen bestimmte Gasdrucke aufweisen.

Hierbei ist vorgesehen dass ein Gasleitwert der Kanüle einer jeden Gaszuführung an das Ausgangsmaterial angepasst ist, um bei einem jeweiligen vorliegenden Gasdruck den Gasstrom durch die Kanüle derart einzustellen, dass eine gewünschte Gasmenge aus deren Austrittsende austritt. Insbesondere können dann für verschiedene Gaszuführungen unterschiedliche Gasleitwerte für deren Kanülen vorgesehen sein. Insbesondere können sich die Kanülen verschiedener Gaszuführungen hinsichtlich ihres Innenquerschnittes oder/und ihre Länge unterscheiden.

Insbesondere ist hierbei vorgesehen, dass für ein Paar von Ausgangsmaterialien, von denen ein erstes Ausgangsmaterial bei einer bestimmten Temperatur, wie etwa Raumtemperatur, einen höheren Dampfdruck aufweist als ein zweites der beiden Ausgangsmaterialien, der Gasleitwert der Kanüle zum Ausströmen des ersten Ausgangsmaterials kleiner ist als der entsprechende Gasleitwert der Kanüle zum Ausströmen des zweiten Ausgangsmaterials.

Insbesondere in Kombination mit der Ausführung, bei der jeweils eine Temperierungsvorrichtung zum Einstellen der Temperatur des Ausgangsmaterials vorgesehen ist, ist es hierbei möglich, durch eine entsprechende Anpassung des Gasleitwerts der Kanüle eine Grobeinstellung des Gasflusses vorzunehmen und eine Feineinstellung des Gasflusses durch Einstellen der Temperatur des Ausgangsmaterials zu erreichen.

Die Erfindung geht aus gemäß Anspruch 1 von einem Materialbearbeitungssystem mit einer Bearbeitungskammer, einer Werkstückhalterung zum Haltern eines zu bearbeitenden Werkstücks in der Bearbeitungskammer und einer Gaszuführungsanordnung zur Zuführung wenigstens eines Reaktionsgases hin zu einem zu bearbeitenden Bereich des Werkstücks sowie einer Vorrichtung zum Richten eines Energiestrahls auf den zu bearbeitenden Bereich des Werkstücks, um dort das Reaktionsgas zu einer Reaktion mit dem Werkstück anzuregen.

Hierbei ist vorgesehen, als Energiestrahl einen Elektronenstrahl einzusetzen, welcher von einem Elektronenmikroskop erzeugt wird. Mit dem Elektronenmikroskop ist es ebenfalls möglich, elektronenmikroskopische Bilder des Werkstücks aufzunehmen, wobei dies vornehmlich in einem Betriebsmodus geschieht, in dem Reaktionsgas nicht zugeführt wird.

Es wird damit das Elektronenmikroskop zum einen eingesetzt, um elektronenmikroskopische Bilder des zu bearbeitenden Werkstücks zu gewinnen, und zum anderen dazu, zugeführtes Reaktionsgas gezielt in solchen Bereichen des Werkstücks zur Reaktion mit diesem anzuregen. Es wird das Elektronenmikroskop damit für zwei Aufgaben eingesetzt, wobei für beide Aufgaben die mit dem Elektronenstrahl mögliche hohe Fokussierung des Elektronenstrahls ausgenutzt wird und damit sowohl eine hochauflösende Bildgebung wie auch eine hochauflösende Bearbeitung des Werkstücks erzielbar ist.

Ferner kann auch während des Zuführens des Reaktionsgases ein Signal des Sekundärelektronendetektors des Elektronenmikroskops dazu verwendet werden, den Materialbearbeitungsprozess zu überwachen, da sich eine Intensität der Sekundärelektronen während des Ablaufs der Reaktion und zunehmender Materialabscheidung bzw. zunehmendem Materialabtrag von dem Werkstück ändern kann.

Insbesondere ist es hierbei möglich, zuerst unter Zuführung von Gas und Richten des Elektronenstrahls an ausgewählte Orte des Werkstücks an diesen Bearbeitungen vorzunehmen und so dann bei abgeschalteter Gaszuführung ein elektronenmikroskopisches Bild des Werkstücks aufzunehmen und dieses Bild mit einem Sollbild des Werkstücks zu vergleichen. Es können dann die Orte des Werkstücks identifiziert werden, an denen das Bild des Werkstücks von dem Sollbild abweicht, um an diesen Orten in einem nächsten Schritt unter Zuführung von Reaktionsgas weitere Bearbeitungen vorzunehmen.

Der Einsatz des Elektronenmikroskops für die Bildgebung und für die Auslösung der Gasreaktion ist besonders dann vorteilhaft, wenn das zu bearbeitende Werkstück eine Maske zur Verwendung in einem Lithographieverfahren ist, da dort besonders hoch auflösende materialbearbeitende Manipulationen an der Maske vorzunehmen sind. Ganz besonders von Vorteil ist diese Kombination dann, wenn die Maske eine phasenschiebende Maske (Phasenmaske, PSM) ist. Im Unterschied zu dem herkömmlich verwendeten Ionstrahl zur Auslösung der Gasreaktion, bei welchem auch Ionen in die Maske implantiert werden, führt der Elektronenstrahl nicht zu Implantationen oder ähnlichen Änderungen des Maskenmaterials. Derartige Implantationen sind nämlich bei Phasenschiebemasken zu vermeiden, da die implantierten Materialien selbst eine phasenschiebende Wirkung auf die in dem späteren Lithographieverfahren eingesetzte Strahlung zur Beleuchtung der Maske haben.

Das Elektronenmikroskop umfasst hierbei eine Elektronenquelle zur Erzeugung eines Elektronenstrahls, wenigstens eine Fokussierlinse zum Fokussieren des Elektronenstrahls auf einer Objektebene der Elektronenoptik und wenigstens einen Elektronendetektor zum Detektieren von Sekundärelektronen, die in einem Bereich um die Objektebene entstehen.

Die Werkstückhalterung ist dabei derart ausgebildet, dass das Werkstück relativ zu dem Elektronenmikroskop derart anordnenbar ist, dass eine Oberfläche des Werkstücks im wesentlichen in der Objektebene des Elektronenmikroskops anordnenbar ist. Ferner ist die Gaszuführungsanordnung relativ zu der Werkstückhalterung derart angeordnet, dass die zugeführten Reaktionsgase aus der Gaszuführungsanordnung nahe der Objektebene in einem Bereich um den Elektronenstrahl austreten.

Heirbei umfasst das Elektronenmikroskop wenigstens zwei Druckblenden mit jeweils einer von dem Elektronenstrahl durchsetzten Öffnung, welche drei Vakuumräume teilweise voneinander separieren. Dies ist zum einen der Vakuumraum der Bearbeitungskammer, in der das Werkstück angeordnet ist, und zum anderen ist dies ein Vakuumraum im Inneren des Elektronenmikroskops, in dem unter anderem die Elektronenquelle angeordnet ist. Ferner ist dies noch ein Zwischen-Vakuumraum, der zwischen dem die Elektronenquelle umfassenden Vakuumraum und dem Vakuumraum der Bearbeitungskammer angeordnet ist. Hierdurch ist es möglich, in dem Vakuumraum der Bearbeitungskammer einen höheren Gasdruck aufrecht zu erhalten als in dem die Elektronenquelle umfassenden Vakuumraum. Die Elektronenquelle benötigt zum Betrieb nämlich ein besonders gutes Vakuum, während der Bearbeitungskammer Reaktionsgase zugeführt werden, was dort zu einem höheren Gasdruck führt. Hierbei ist es ebenfalls möglich, in dem die Elektronenquelle umfassenden Vakuumraum noch weitere durch Druckblenden separierte Vakuumräume vorzusehen, um für die Elektronenquelle selbst ein noch besseres Vakuum bereitzustellen.

Hierbei ist der Elektronendetektor zur Aufnahme der elektronenmikroskopischen Bilder in dem Vakuumraum angeordnet. Hierdurch wird eine Schädigung des Detektors durch die meist aggressiven Reaktionsgase, die der Bearbeitungskammer zugeführt werden, reduziert.

Es ist dann weiter vorgesehen, dass eine der Objektebene nächstliegende Fokussierlinse des Elektronenmikroskops zwischen dem Detektor und der Objektebene angeordnet ist. Hierdurch ist ein besonders kleiner Abstand zwischen der der Objektebene nächstliegenden Fokussierlinse und der Objektebene möglich, da der Elektronendetektor nicht in einem Raum zwischen der der Objektebene nächstliegenden Fokussierlinse und Objektebene angeordnet werden muss. Dieser geringe Arbeitsabstand ermöglicht eine besonders feine Fokussierung des Elektronenstrahls in der Objektebene. Vorzugsweise ist eine separate Vakuumpumpe vorgesehen, um den Zwischen-Vakuumraum in einem Bereich neben der Druckblende zu evakuieren. Diese separate Vakuumpumpe ist vorzugsweise eine Turbomolekularpumpe.

Es ist vorgesehen, einen begrenzten Teilraum zwischem dem Werkstück und dem Elektronenmikroskop von dem möglichen Vakuumraum der Bearbeitungskammer zu separieren, wobei das wenigstens eine Reaktionsgas dann unmittelbar diesem so gebildeten Teilraum zugeführt wird. Das zugeführte Reaktionsgas wird damit in diesem Teilraum relativ zu dem übrigen Raum der Bearbeitungskammer unter einem erhöhten Druck gehalten und strömt nicht ungehindert in das gesamte Volumen der Bearbeitungskammer ab. Dies ermöglicht einen sparsamen Umgang mit dem Reaktionsgas und weiter eine schnelle Einstellung eines gewünschten Partialdruckes des Reaktionsgases in dem Teilraum.

Hierbei ist zur Bildung eines solchen Teilraums eine der Objektebene am nächsten angeordnete Komponente des Elektronenmikroskops derart ausgebildet, dass sie eine den Elektronenstrahl ringförmig umschließende im wesentlichen plane und der Objektebene zuweisende Endfläche aufweist.

Diese Endfläche weist von der Objektebene einen Abstand von weniger als 100 $\mu$m, vorzugsweise weniger als 50 $\mu$m auf. Hierdurch ist es möglich, ohne Berührung zwischen der Endfläche und dem zu bearbeitenden Werkstück den Teilraum ausreichend gegenüber der übrigen Bearbeitungskammer zu separieren, so dass innerhalb des Teilraums erhöhte Drücke des wenigstens einen Reaktionsgases aufgebaut werden können.

Vorzugsweise ist die der Objektebene am nächsten angeordnete Komponente des Elektronenmikroskops als Dichtung zur Anlage an dem Werkstück ausgebildet.

Hierbei ist vorgesehen, dass die Druckblende selbst zwischen der der Objektebene nächstliegenden Fokussierlinse des Elektronenmikroskops und der Objektebene angeordnet ist. Es müssen bei dieser Ausgestaltungen die aus der Objektebene austretenden Sekundärelektronen einen vergleichsweise kurzen Weg unter den schlechten Vakuumbedingungen in dem Teilraum durchlaufen, bevor sie durch die Druckblende in das wesentlich bessere Vakuum des Zwischen-Vakuumraums und dann des die Elektronenquelle umfassenden Vakuumraums eintreten und dort von dem Detektor registriert werden.

Zusätzlich kann ferner ein zweiter Elektronendetektor in der Bearbeitungskammer vorgesehen sein, dessen Detektionssignale insbesondere dann erfasst werden, wenn die Vakuumbedingungen in der Bearbeitungskammer so schlecht sind, dass der innerhalb des Zwischen-Vakuumraums angeordnete erste Elektronendetektor keine zufriedenstellenden Signale liefert.

Das Materialbearbeitungssystem umfasst vorzugsweise eine Steuerung, mit der das System zwischen einem ersten Betriebsmodus und einem zweiten Betriebsmodus umschaltbar ist, wobei in dem ersten Betriebsmodus in der Bearbeitungskammer ein wesentlich geringer Gasdruck herrscht als in dem zweiten Betriebsmodus. In dem ersten Betriebsmodus wird vorzugsweise kein Reaktionsgas zugeführt, und es werden in diesem Betriebsmodus auch vorzugsweise die elektronenmikroskopischen Bilder des zu bearbeitenden Werkstücks aufgenommen. In dem zweiten Betriebsmodus wird vorzugsweise Reaktionsgas zu dem Werkstück geführt, um daran eine Materialbearbeitung vorzunehmen.

Der Bearbeitungsraum wird vorzugsweise durch eine separate Vakuumpumpe, insbesondere eine Turbomolekularpumpe, abgepumpt, wobei diese Pumpe in dem zweiten Betriebsmodus vorzugsweise ausser Betrieb steht.

Gemäß einer Ausführungsform des erfindungsgemäßen Materialbearbeitunssystem umfasst die Gaszuführungsanordnung mit wenigstens einer Gaszuführung zum Zuführen des Reaktionsgases zu einem Reaktionsort, wobei die Gaszuführung umfasst:

ein Rohr mit einem ersten Innenquerschnitt und einen in dem Rohr verschiebbaren Ventilkörper, der zwischen einer ersten Stellung, in der ein Gasfluss durch das Rohr freigegeben ist, und einer zweiten Stellung, in der der Gasfluss durch das Rohr im wesentlichen versperrt ist, hin und her verlagerbar ist, wobei eine Kanüle mit einem an das Rohr gekoppelten Eintrittsende für den Gasfluss und einem Austrittsende für den Gasfluss, wobei die Kanüle in einem Bereich ihres Austrittsendes einen zweiten Innenquerschnitt aufweist, der kleiner ist als der erste Innenquerschnitt und wobei ein Volumen (V) eines zusammenhängenden Gasraumes, der wenigstens durch die Kanüle, den Innenquerschnitt der Kanüle an deren Austrittsende und den Ventilkörper in dessen zweiter Stellung begrenzt ist, folgende Relation erfüllt:

$$V < c * A * l$$

wobei A eine Fläche des Innenquerschnitts der Kanüle an deren Austrittsende ist,
l ein Abstand zwischen dem Austrittsende der Kanüle und dem Ventilkörper in dessen zweiter Stellung ist und
c eine Konstante ist mit c < 5, vorzugsweise c < 3 und weiter bevorzugt c < 1,5.

Gemäß einer weiteren Ausführungsform gilt für die Gaszuführungsanordnung: c < 1,2, vorzugsweise c < 1,1 und weiter bevorzugt c ist im wesentlichen gleich 1.

Ferner ist gemäß einer Ausführungsform bei der Gaszuführungsanordnung ein Aussendurchmesser der Kanüle kleiner als ein Innendurchmesser des Rohres.

Gemäß einer weiteren Ausführungsform umfasst die Gaszuführungsanordnung ferner ein Reservoir zur Aufnahme eines festen oder/und flüssigen Ausgangsmaterials zur Bereitstellung des Reaktionsgases, wobei das Reservoir eine Temperierungsvorrichtung zum Einstellen einer Temperatur des Ausgangsmaterials.

Gemäß einer weiteren Ausführungsform umfasst die Temperierungsvorrichtunginsbesondere eine Kühlvorrichtung, die dazu ausgebildet ist, die Temperatur des Ausgangsmaterials niedriger einzustellen, als eine Temperatur der Kanüle.

Gemäß einer weiteren Ausführungsform umfasst die Gaszuführungsanordnung ferner eine Heizung zum Heizen der Kanüle oder/und des Rohrs.

Des Weiteren umfasst gemäß einer Ausführungsform die Gaszuführungsanordnung ferner einen Drucksensor zum Messen eines Gasdruckes des Reaktionsgases und eine Steuerung zur Ansteuerung der Temperierungsvorrichtung in Abhängigkeit von dem gemessenen Gasdruck.

Ferner sind gemäß einer weiteren Ausführungsform bei der Gaszuführungsanordnung wenigstens zwei Gaszuführungen (55) vorgesehen und das Reservoir einer ersten der beiden Gaszuführungen enthält ein erstes Ausgangsmaterial und das Reservoir einer zweiten der beiden Gaszuführungen enthält ein von dem ersten Ausgangsmaterial verschiedenes zweites Ausgangsmaterial , wobei ein Gasleitwert (L) der Kanüle der ersten Gaszuführung von einem Gasleitwert (L) der Kanüle der zweiten Gaszuführung verschieden ist.

Ferner weist gemäß einer weiteren Ausführungsform bei der Gaszuführungsanordnung bei einer Temperatur von 20 °C das erste Ausgangsmaterial einen höheren Dampfdruck auf als das zweite Ausgangsmaterial und der Gasleitwert (L) der ersten Kanüle ist kleiner als der Gasleitwert (L) der zweiten Kanüle.

Erfindungsgemäß weist das Materialbearbeitungssystem wenigstens ein Paar von Druckblenden mit jeweils einer von dem Elektronenstrahl durchsetzten Öffnung auf, wobei eine erste der beiden Druckblenden einen Vakuumraum der Bearbeitungskammer von einem Zwischen-Vakuumraum teilweise separiert und eine zweite der beiden Druckblenden den Zwischen-Vakuumraum von einem die Elektronenquelle umfassenden Vakuumraum teilweise separiert, wobei eine Vakuumpumpanordnung einen ersten Anschluss zum Zwischen-Vakuumraum aufweist, und wobei ein erster Elektronendetektor in dem Zwischen-Vakuumraum angeordnet ist.

Bei dem erfindungsgemäßen Materialbearbeitungssystem weist eine der Objektebene am nächsten angeordnete Komponente des Elektronenmikroskops eine den Elektronenstrahl ringförmig umschließende im wesentlichen plane der Objektebene zuweisende Endfläche auf.

Gemäß einer Ausführungsform des Materialbearbeitungssystems ist eine der Objektebene nächstliegende Fokussierlinse des Elektronenmikroskops zwischen dem ersten Detektor und der Objektebene angeordnet.

Gemäß einer weiteren Ausführungsform des Materialbearbeitungssystems ist dem ersten Anschluss eine separate Turbomolekularpumpe zum Abpumpen des Zwischen-Vakuumraums zugeordnet.

Gemäß einer Ausführungsform des Materialbearbeitungssystems ist die der Objektebene am nächsten angeordnete Komponente des Elektronenmikroskops als Dichtung zur Anlage an dem Werkstück ausgebildet.

Ferner ist gemäß einer Ausführungsform des Materialbearbeitungssysems die Werkstückhalterung dazu ausgebildet, das Werkstück von der Anlage an der als Dichtung ausgebildeten Komponente zu entfernen.

Gemäß einer weiteren Ausführungsform des Materialbearbeitungssystems ist ein Ventil vorgesehen, um einen von der Dichtung umschlossenen Gasraum in Verbindung mit dem Vakuumraum der Bearbeitungskammer zu setzen.

Des Weiteren ist gemäß einer Ausführungsform die Druckblende zwischen der der Objektebene nächstliegenden Fokussierlinse des Elektronenmikroskops und der Objektebene angeordnet.

Gemäß einer weiteren Ausführungsform ist ein zweiter Elektronendetektor in der Bearbeitungskammer angeordnet.

Des Weiteren weist gemäß einer weiteren Ausführungsform des Materialbearbeitungssystems die Vakuumpumpanordnung einen zweiten Anschluss zu dem Vakuumraum der Bearbeitungskammer auf.

Ferner umfasst das Materialbearbeitungssystem gemäß einer Ausführungsform eine Steuerung zum umschalten der Vakuumpumpanordnung zwischen einem ersten und einem zweiten Betriebsmodus, wobei in dem ersten Betriebsmodus die Bearbeitungskammer über den zweiten Anschluss stärker evakuierbar ist als in dem zweiten Betriebsmodus.

Des Weiteren ist gemäß einer weiteren Ausführungsform des Materialbearbeitungssystems dem zweiten Anschluss eine separate Turbomolekularpumpe zugeordnet, die in dem zweiten Betriebsmodus ausser Betrieb ist.

Ferner ist gemäß einer Ausführungsform in dem Materialbearbeitungssystem ein Gasdruck in der Bearbeitungskammer in dem ersten Betriebsmodus kleiner als etwa 0.05 mbar und in dem zweiten Betriebsmodus größer als 0,1 mbar.

Des Weiteren umfasst das Materialbearbeitungssystem nach einer Ausführungsform ferner einen energieauflösenden Photonen-Detektor, insbesondere Röntgen-Detektor, zur Detektion von aus dem Werkstück aufgrund einer Wechselwirkung mit dem Elektronenstrahl austretenden Photonen.

Gemäß einem weiteren Aspekt der Erfindung wird ein Verfahren zum Bearbeiten eines Werkstücks bereitgestellt, umfassend:

- Aufnehmen eines elektronenmikroskopischen Bildes eines Bereichs des Werkstücks durch Richten eines Elektronenstrahls an eine Vielzahl von Orten innerhalb des Bereichs und registrieren von aus dem Werkstück austretenden Sekundärelektronen in Abhängigkeit von den Orten, auf die der Elektronenstrahl gerichtet ist,
- Festlegen wenigstens eines Ortes innerhalb des Bereichs des Werkstücks, an dem Material des Werkstücks abzutragen ist oder an dem Material an dem Werkstück abzuscheiden ist,
- Zuführen wenigstens eines Reaktionsgases zu dem Bereich des Werkstücks,
- Richten des Elektronenstrahls des auf den wenigstens einen bestimmten Ort des Werkstücks, um das wenigstens eine Reaktionsgas zu einer Reaktion mit dem Werkstück anzuregen.

Das erfindungsgemäße Verfahren wird unter Einsatz des erfindungsgemäßen Materialbearbeitungssystems ausgeführt.

Ferner erfolgt gemäß einer Ausführungsform des Verfahrens das Aufnehmen des elektronenmikroskopischen Bildes nach der Anregung der Reaktion und ferner wird in Abhängigkeit von dem aufgenommenen Bild wenigstens ein weiterer Ort innerhalb des Bereichs des Werkstücks festgelegt, an dem Material von dem Werkstück abzutragen oder an diesem abzuscheiden ist.

Gemäß einer weiteren Ausführungsform des Verfahrens ist in dem Verfahren das Werkstück eine Maske zur Verwendung in einem Lithographieverfahren, insbesondere eine Photomaske und weiter bevorzugt eine Phasenmaske.

Beispiele, die das Verständnis der Erfindung erleichtern, und Ausführungsformen der Erfindung werden nachfolgend anhand von Figuren erläutert. Hierbei zeigt:

Figur 1    ein Beispiel eines Materialbearbeitungs- systems mit Gaszuführungsanordnung in schema- tischer Darstellung,

Figur 2    die Gaszuführungsanordnung der Figur 1 im Detail,

Figur 3    eine Detailansicht zu Figur 2,

Figur 4    einen Schnitt entlang Linie IV-IV in Figur 3,

Figur 5    eine Aüsführungsform eines erfindungsgemäßen Materialbe- arbeitungssystems,

Figur 6      eine Detailansicht der Figur 5,

Figur 7      eine Variante zu Figur 6, und

Figur 8      eine Variante des in Figur 3 dargestellten Teils der Gaszuführungsanordnung,

Figur 9      eine Variante der in Figur 2 dargestellten Gaszu- führungsanordnung.

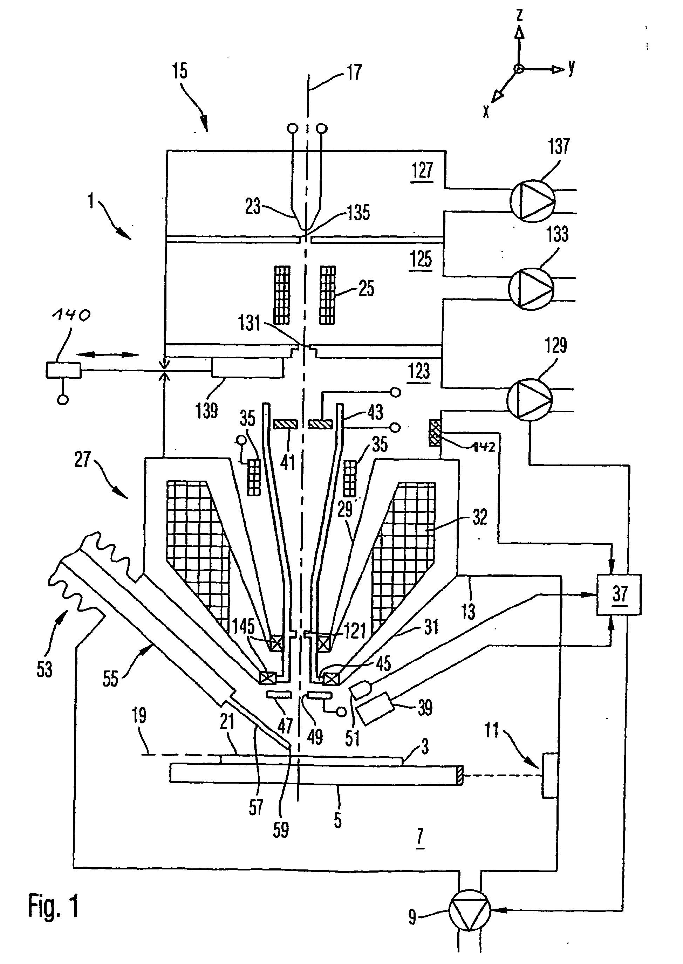

In Figur 1 ist ein Beispiel eines-Materialbearbeitungssystems 1 schematisch dargestellt. Dieses dient zur Bearbeitung eines Werkstücks 3, nämlich einer Phasenmaske. Diese Photomaske ist zur Verwendung in einem Photolithographieverfahren vorgesehen und trägt Strukturen, die photographisch auf eine strahlungsempfindliche Schicht ("resist") übertragen werden, mit der ein Halbleitersubstrat ("wafer") beschichtet ist. Bezogen auf die Wellenlänge des zur Übertragung der Strukturen von der Maske auf das Halbleitersubstrat verwendeten Lichts sind die kritischen Abmessungen der Strukturen relativ klein, weshalb die Strukturen auf der Maske nicht lediglich als abwechselnd transparente und absorbierende Strukturen verkörpert sind, sondern auch eine definierte phasenschiebende Wirkung für das zur Abbildung verwendete Licht bereitstellen sollen. Entsprechend müssen die Strukturen der Maske 3 vorgegebene Grenzen für ortsabhängige Materialdichten relativ genau einhalten.

Mit dem Materialbearbeitungssystem 1 ist es möglich, derartige Strukturen durch Materialabscheidung an ausgewählten Orten zu erzeugen oder auch durch Materialabtrag an ausgewählten Orten zu entfernen.

Die Materialabscheidung erfolgt hierbei durch Zuführen eines Reaktionsgases ("precursor") in die Nähe des zur Bearbeitung ausgewählten Ortes. Auf den ausgewählten Ort wird gleichzeitig ein Elektronenstrahl aus Primärelektronen gerichtet, wobei die Primärelektronen selbst oder durch diese aus dem Werkstück ausgelöste Rückstreu- oder Sekundärelektronen das Reaktionsgas aktivieren, so dass sich Komponenten des Reaktionsgases an dem ausgewählten Ort oder in dessen naher Umgebung ablagern, wodurch die gewünschte Materialabscheidung im Bereich des ausgewählten Ortes erfolgt.

Der Materialabtrag erfolgt auf ähnliche Weise, wobei allerdings ein anderes Reaktionsgas zugeführt wird, welches durch die Primärelektronen oder die daraus entstehenden Rückstreuoder Sekundärelektronen derart aktiviert wird, dass es an dem ausgewählten Ort oder dessen naher Umgebung mit dem Material des Werkstücks reagiert und Komponenten desselben in eine gas- oder dampfförmige Verbindung überführt, so dass sich diese von dem Werkstück entfernen und schließlich der gewünschte Materialabtrag im Bereich des ausgewählten Ortes entsteht.

Hierzu ist das Werkstück 3 auf einer Werkstückhalterung 5 fest angebracht. Werkstückhalterung 5 und Werkstück 3 sind in einer Bearbeitungskammer 7 angeordnet, welche mittels einer Turbomolekularpumpe 9 und einer in Figur 1 nicht dargestellten Vorpumpe evakuierbar ist.

Eine räumliche Position der Werkstückhalterung 5 relativ zur Bearbeitungskammer ist mittels in Figur 1 nicht dargestellten Antrieben in den drei Raumrichtungen x, y, z verlagerbar. Mehrere Laserinterferometer 11 sind vorgesehen, um die Position der Werkstückhalterung 5 relativ zur Bearbeitungskammer 7 zu erfassen.

An einen Vakuummantel 13 der Bearbeitungskammer 7 ist ein Elektronenmikroskop 15 derart angebracht, dass sich dessen optische Achse 17 in z-Richtung erstreckt und eine Objektebene 19 des Elektronenmikroskops 15 innerhalb der Bearbeitungskammer 7 legt. Die Werkstückhalterung 5 ist innerhalb der Bearbeitungskammer 7 derart positioniert, dass eine Oberfläche 21 des Werkstücks 3 im wesentlichen in der Objektebene 19 des Elektronenmikroskops 15 angeordnet ist.

Das Elektronenmikroskop 15 umfasst eine elektronenemittierende Elektronenquelle 23 und eine als Kondensor wirkende Magnetwicklung 25, um aus den emittierten Elektronen einen Elektronenstrahl zu formen, der entlang der Achse 17 nach unten gerichtet ist. Eine Objektivlinse 27 des Elektronenmikroskops 15 umfasst einen oberen Polschuh 29 und einen unteren Polschuh 31, zwischen denen eine Wicklung 32 vorgesehen ist und die zur Achse 17 hin einen Polschuhspalt definieren. Die Objektivlinse 27 fokussiert den Elektronenstrahl in der Objektebene 19.

Ferner sind Ablenkwicklungen 35 vorgesehen, um den Elektronenstrahl aus der optischen Achse 17 des Elektronenmikroskops 15 in x- und y-Richtung auszulenken. Ein Strom durch die Ablenkwicklungen 35 und damit die Auslenkung des Elektronenstrahls in x- und y-Richtung wird mittels eine Steuerung 37 eingestellt.

Zwischen der Objektivlinse 27 und der Objektebene 19 ist innerhalb der Bearbeitungskammer 7 ein Sekundärelektronendetektor 39 angeordnet, dessen Detektionssignal von der Steuerung 37 ausgelesen wird. Zur Aufnahme eines elektronenmikroskopischen Bildes des Werkstücks 3 in einem in der Objektebene 19 um die Achse 17 gelagerten Bereich steuert die Steuerung 37 die Ablenkwicklungen 35 derart an, dass der Elektronenstrahl diesen Bereich systematisch abtastet, und die von dem Detektor 39 in Abhängigkeit von der Auslenkung registrierten Intensitäten werden von der Steuerung 37 für eine Weiterverarbeitung gespeichert oder an einem Sichtgerät ausgegeben.

Ein weiterer Sekundärelektronendetektor 41, der ebenfalls von der Steuerung 37 ausgelesen wird, ist innerhalb des Elektronenmikroskops 15 konzentrisch um dessen Achse 19 angeordnet. Dieser ist innerhalb eines zur Achse 17 symmetrischen und nach unten konisch sich verjüngenden Strahlrohrs 43 angeordnet, welches zur Objektebene 19 hin in einem sich radial von der Achse wegerstreckenden Kragen 45 auf der Höhe des Endes des unteren Polschuhs 31 endet. Zwischen dem Kragen 45 und der Objektebene 19 ist eine Blende 47 mit einer Bohrung 49 von 5 mm Durchmesser angeordnet. Es sind durch die Steuerung 37 ansteuerbare und in Figur 1 nicht dargestellte Spannungsquellen vorgesehen, um das Strahlrohr 43 und die Blende 47 auf einstellbare elektrische Potentiale zu legen. In einem Betriebsmodus des Systems 1, bei dem in der Bearbeitungskammer 7 relativ gute Vakuumbedingungen mit einem Gasdruck von kleiner $10^{-3}$ mbar herrschen, liegt das Strahlrohr 43 auf einem Potential von 8 kV und die Blende 47 auf Erdpotential. Damit entsteht zwischen dem Kragen 45 und der Blende 47 ein elektrisches Feld, welches zum einen verzögernd und fokussierend auf die Primärelektronen des Elektronenstrahls wirkt und zum anderen Sekundärelektronen, die aus dem Werkstück 3 austreten und sich in einem die Achse 17 umschließenden Raumwinkelbereich bewegen, beschleunigt, so dass sich diese mit erhöhter kinetischer Energie entlang der Achse 17 nach oben bewegen und den Sekundärelektronendetektor 41 treffen und von diesem registriert werden.

In diesem Betriebsmodus ist es vorteilhaft, den Detektor 41 zur Aufnahme der elektronenmikroskopischen Bilder des Werkstücks 3 einzusetzen und den anderen Sekundärelektronendetektor 39 ausser Betrieb zu nehmen, da dann ein für den Betrieb des Detektors 39 notwendiges elektrostatisches Beschleunigungsfeld die Fokussierung der Primärelektronen auf das Werkstück 3 nicht stört.

Ferner kann der in der Bearbeitungskammer 39 angeordnete Sekundärelektronendetektor an einer für den Betrieb desselben nicht optimalen Stelle in der Bearbeitungskammer angeordnet sein, was es allerdings ermöglicht, einen vergleichsweise geringen Abstand zwischen der Blende 47 und der Objektebene 19 vorzusehen. Dies wiederum ermöglicht eine besonders feine Fokussierung des Elektronenstrahls in der Objektebene 19 und damit eine besonders hohe Ortsauflösung des Elektronenmikroskops 15.

In Ergänzung zu den Elektronendetektoren 39 und 41 ist ein energieauflösender Photonendetektor 51 in der Bearbeitungskammer angeordnet, welcher Röntgenstrahlung energieaufgelöst registriert, welche aus dem Werkstück 3 im Bereich der Achse 17 austritt. Durch Auswerten der Energiespektren der durch die Primärelektronen in dem Werkstück 3 induzierten Röntgenstrahlung ist es möglich, Aussagen über die Materialzusammensetzung des Werkstücks 3 an dem Ort zu treffen, auf der den der Elektronenstrahl gerade fokussiert ist.

An dem Vakuummantel 13 der Verarbeitungskammer 7 ist neben dem Elektronenmikroskop 15 noch eine Gaszuführungsanordnung 53 angeflanscht. Diese umfasst mehrere Gaszuführungen 55, welche jeweils eine Kanüle 57 aufweisen, um ein Reaktionsgas in die Bearbeitungskammer zu dem Werkstück 3 hin zu leiten, wozu Austrittsenden 59 der Kanülen 57 etwa 0,5 mm oberhalb der Objektebene 19 und 1 bis 2 mm entfernt von der Achse 17 angeordnet sind.

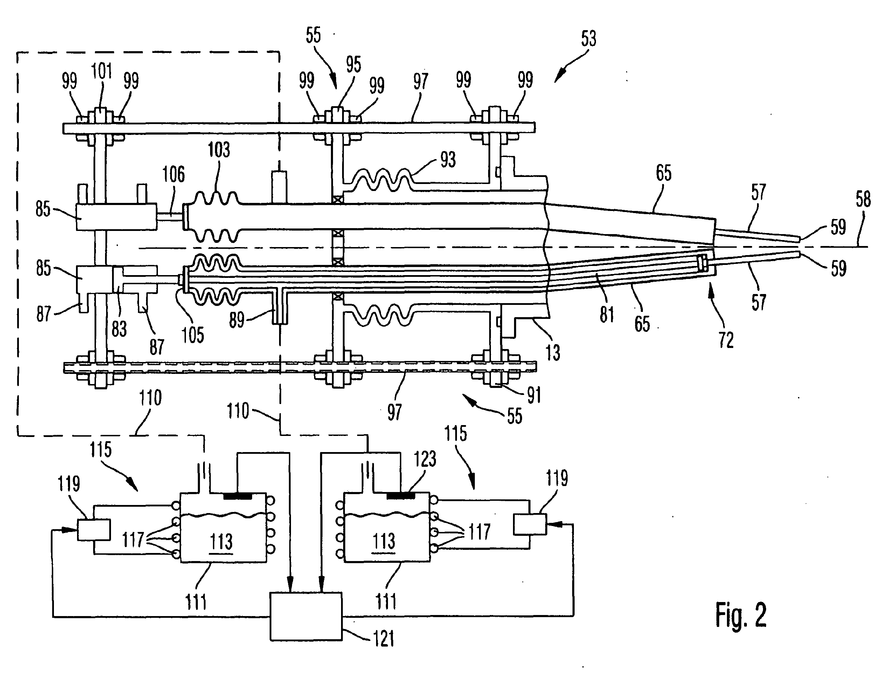

Die Gaszuführungsanordnung 53 ist in den Figuren 2 bis 4 im Detail dargestellt und umfasst vier symmetrisch um eine Achse 58 angeordnete Gaszuführungen 55, von denen zwei in Figur 2 sichtbar sind.

Die Kanülen 57 haben einen Innendurchmesser von 0,7 mm bis 1,5 mm und einen entsprechenden Aussendurchmesser von 1,0 mm bis 1,8 mm. Ein zu dem in der Nähe der Achse 17 des Elektronenmikroskops 15 angeordneten Austrittsende 59 entgegengesetztes Eintrittsende 61 der Kanüle 57 ist in einer Stirnwand 63 eines runden Rohrs 65 aufgenommen, welches einen Innendurchmesser von 4 mm aufweist. Im Inneren des Rohres 65 ist ein kreisringförmiger Dichtungsring 71 vorgesehen, welcher sowohl an einer Innenwand 69 des Rohrs 65 als auch an einer Innenfläche 73 der Stirnwand 63 des Rohrs anliegt.

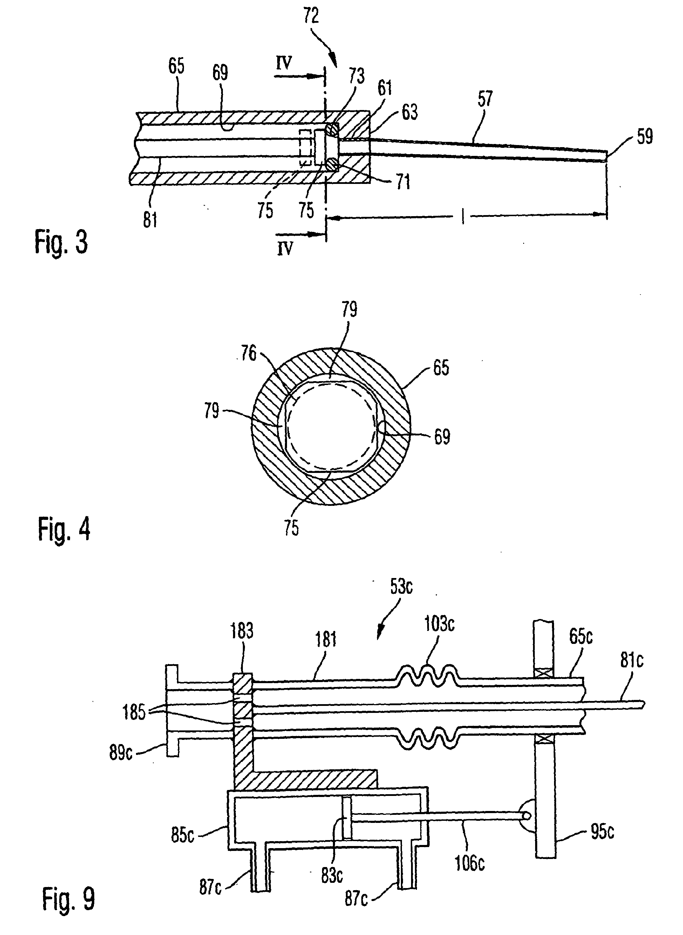

Der Dichtungsring 71 ist Teil eines Ventils 72, welches einen Gasfluss vom Inneren des Rohres 65 in die Kanüle 57 wahlweise versperrt und freigibt. In einer den Gasfluss versperrenden Stellung des Ventils 72 ist ein Ventilkörper 75 mit seiner Stirnfläche gegen den Dichtring 71 gedrückt, wobei eine Berührungsfläche zwischen Dichtring 71 und der Stirnseite des Ventilkörpers 75 in Figur 4 mit einer gestrichelten Linie 76 angedeutet ist.

In der den Gasfluss freigebenden Stellung des Ventils 72 ist der Ventilkörper 75 mit Abstand von dem Dichtring 71 angeordnet, wie dies in Figur 3 mit gestrichelten Linien dargestellt ist.

Aus Figur 4 ist ersichtlich, dass der Ventilkörper 75 einen quadratischen Querschnitt mit abgerundeten Ecken aufweist, so dass der Ventilkörper mit seinen abgerundeten Ecken an dem Innenmantel 69 des Rohrs 65 geführt ist, während zwischen einem jeden Paar von abgerundeten Ecken ein Bereich des Ventilkörpers 75 einen vergrößerten Abstand von dem Innenmantel 69 des Rohrs 65 aufweist, um vier Durchtrittsquerschnitte 79 bereitzustellen, durch welche das Reaktionsgas den Ventilkörper 75 im Inneren des Rohrs 65 umfließen und dann in der von dem Dichtring 71 entfernten Stellung des Ventilkörpers 75 in die Kanüle 57 eintreten kann.

Das Ventil 72 wird durch eine Stange 81 betätigt, welche sich koaxial zu dem Rohr 65 erstreckt und an deren einem Ende der Ventilkörper 75 festgemacht ist und an deren anderem Ende ein Kolben 83 festgemacht ist, welcher innerhalb eines Pneumatikzylinders 85 verschiebbar gelagert ist.

Der Pneumatikzylinder 85 weist zwei Druckluftanschlüsse 87 auf, an welche wahlweise Druckluft angelegt wird, um den Ventilkörper 75 entweder gegen die Dichtung 71 zu drücken und damit den Gasfluss in die Kanüle zu versperren oder diesen von der Dichtung 71 zu entfernen und damit den Gasfluss in die Kanüle freizugeben. Das Reaktionsgas wird hierbei über einen Anschluss 89, der über ein T-Stück in das Rohr 65 eingefügt ist, dem Inneren des Rohrs 65 zugeführt.

Ein Flansch 91 zur Verbindung mit dem Vakuummantel 13 der Bearbeitungskammer 7 umschließt die Rohre 65 der vier Gaszuführungen 55. Mit diesem Flansch 91 ist ein Ende eines Faltenbalgs 93 vakuumdicht verbunden, dessen anderes Ende mit einem Flansch 95 vakuumdicht verbunden ist, welchen die Rohre 65 einzeln und vakuumdicht durchsetzen, wobei die Rohre 65 mit diesem Flansch 95 auch mechanisch fest verbunden sind. Zwischen den Flanschen 91 und 95 erstrecken sich parallel zu dem Faltenbalg 93 mehrere Gewindestangen 97, an denen die Flansche 91 und 95 mittels Muttern 99 fixiert sind. Durch Verdrehen der Muttern 99 lassen sich die Abstände zwischen den Flanschen 91 und 95 ändern und damit die Positionen der Austrittsenden 95 der Kanülen 57 relativ zu der Objektebene 19 und der Achse 17 des Elektronenmikroskops 15 justieren, wenn die Gaszuführungsanordnung 53 an dem Vakuummantel 13 der Bearbeitungskammer 7 festgemacht ist.

Die Gewindestangen 97 tragen weiterhin eine Platte 101, an welcher die Druckluftzylinder 85 zur Betätigung der Ventile 72 festgelegt sind. Die Rohre 65 gehen an ihren von der Kanüle 57 entfernten Enden jeweils in einen Faltenbalg 103 über, welcher durch eine Platte 105 vakuumdicht abgeschlossen ist. An der Platte 105 ist die Stange 81 zur Verschiebung des Ventilkörpers 75 festgemacht. Die Platte 105 wiederum ist mit dem Kolben 83 in dem Druckluftzylinder 85 über eine Stange 106 gekoppelt. Somit wird durch Betätigen des Druckluftzylinders 85 der Faltenbalg gedehnt bzw. zusammengedrückt, was wiederum zu einer Verlagerung des Ventilkörpers 75 in dem Rohr 65 und somit zur Betätigung des Ventils 72 führt.

Wenn das Ventil 72 zu einem bestimmten Zeitpunkt von seinem geöffneten Zustand in seinen den Gasfluss versperrenden Zustand überführt wird, so ist es wünschenswert, dass ab diesem Zeitpunkt im wesentlichen kein Reaktionsgas mehr aus dem Austrittsende 59 der Kanüle 57 austritt. Allerdings ist zum Zeitpunkt des vollständigen Verschliessens des Ventils 72 in dem Raum zwischen dem Ventilkörper 75 und dem Austrittsende 59 der Kanüle 57 noch ein Rest an Reaktionsgas vorhanden, der nachfolgend noch aus dem Austrittsende 59 der Kanüle 57 austreten wird und damit zu einer weiteren Reaktion mit dem Werkstück 3 führen kann.

Jedoch ist vorgesehen, dass das Volumen des zwischen dem Ventilkörper 75 und dem Austrittsende 59 gebildeten Gasraumes vergleichsweise klein ist. Hierbei ist anzumerken, dass ein gewisses Volumen dieses Raumes nicht zu vermeiden ist, da ja das Reaktionsgas mittels der Kanüle 57 zu dem Reaktionsort nahe des Werkstücks 3 geführt wird. Die Kanüle 57 muss einen bestimmten Gasleitwert und damit einen bestimmten Querschnitt mindestens aufweisen, um einen gewünschten Gasstrom hin zu dem Werkstück 3 zu ermöglichen. Hierbei ist es allerdings möglich, dass der Querschnitt der Kanüle 57 kleiner ist als ein Mindestquerschnitt des Ventils 72, wodurch der Vorteil entsteht, dass in der Nähe des Bearbeitungsortes keine großvolumigen Komponenten wie etwa der Ventilkörper 75 anzuordnen sind.

Das Ventil 72 und dessen Übergang in die Kanüle 57 sind nun so ausgelegt, dass im geschlossenen Zustand des Ventils 72 der Gasraum zwischen dem Ventilkörper 75 und dem Austrittsende 59 der Kanüle 57 nicht wesentlich größer ist als das Volumen der Kanüle 57 selbst. Unter Bezugnahme auf Figur 3 setzt sich das Volumen dieses Gasraumes zusammen aus dem Volumen der Kanüle 57 und einem Volumen, das axial einerseits durch die Innenfläche 73 der Stirnwand 63 des Rohrs 65 und andererseits durch die der Kanüle zuweisende Stirnfläche des Ventilkörpers 75 begrenzt ist und welches radial durch den Dichtring 71 begrenzt ist. Der kleine Radius des Dichtrings 71 beträgt etwa 0,5 mm und der Innenradius des Dichtrings 71 beträgt etwa 1,0 mm. Damit hat das Volumen zwischen dem Ventilkörper 75 und der Stirnwand 73 einen Wert von etwa 1,5 mm$^3$. Die Kanüle hat bei einem Innendurchmesser von 1,0 mm und einer Länge von 50 mm ein Volumen von etwa 40 mm$^3$. Insgesamt hat das Volumen zwischen dem Austrittsende der Kanüle 59 und der Stirnfläche des Ventilkörpers 75 in der geschlossenen Stellung des Ventils 72 somit ein Volumen von 41,5 mm$^3$. Die in Figur 3 eingetragene Länge 1 ist die Summe aus der Länge der Kanüle und dem kleinen Durchmesser des Dichtrings 71 und beträgt somit etwa 51 mm.

Ein Wert c eines Verhältnisses aus Volumen des Gasraumes geteilt durch Querschnitt der Kanüle 57 an ihrem Austrittsende 59 mal Länge $\left( c = \dfrac{V}{A \cdot l} \right)$ hat somit einen Wert von etwa 1,05. Dies bedeutet, dass bei der in Figur 3 gezeigten Realisierung des Ventils 72 und dessen Übergang in die Kanüle 57 das Volumen des Gasraums zwischen Austrittsende der Kanüle 59 und Ventilkörper 75 in seiner den Gasfluss versperrenden Stellung lediglich 1,05 mal größer ist als das durch die Kanüle 57 selbst vorgegebene Volumen. Damit ist eine Zeitdauer, während der nach Schließen des Ventils noch Reaktionsgas in einer nennenswerten Menge aus dem Austrittsende 59 der Kanüle austritt, nahezu minimal.

Die Bereitstellung der Reaktionsgase wird nachfolgend unter Bezugnahme auf Figur 2 weiter erläutert.

Der mit dem Inneren des Rohres 65 in Verbindung stehende Stutzen 89 ist über einen Schlauch 110 mit einem Reservoir 111 verbunden, in dem ein Ausgangsmaterial 113 des Reaktionsgases aufgenommen ist. Einer jeden Gaszuführung 55 ist ein separates Reservoir 111 mit entsprechendem darin enthaltenem Ausgangsmaterial 113 zugeordnet. Das Ausgangsmaterial 113 liegt in dem Reservoir 111 in fester oder flüssiger Form vor. Das Reaktionsgas entsteht durch Verdunstung, Verdampfung bzw. Sublimation des Ausgangsmaterials. Bei geschlossenem Ventil 72 bildet sich in dem zusammenhängenden Gasraum von Reservoir 111 bis Ventil 72 ein Partialdruck an Reaktionsgas aus, der im wesentlichen gleich dem Dampfdruck des Ausgangsmaterials 113 ist. Wird nun das Ventil 72 geöffnet, entsteht eine Strömung des Reaktionsgases, so dass dieses bei dem Austrittsende 59 aus der Kanüle 57 austritt. Dieser Gasfluss wird im wesentlichen durch den Gasleitwert 57 der Kanüle limitiert, da der Querschnitt der Kanüle 57 wesentlich geringer ist als Querschnitte der übrigen Komponenten des Gasleitungssystems, wie etwa der Querschnitt des Rohrs 65, der Querschnitt des Stutzens 89 oder des Schlauches 110.

Der Gasleitwert L [1/sec] einer Röhre mit Durchmesser d [cm] und Länge 1 [cm] lässt sich unter den angestrebten Betriebsbedingungen abschätzen zu

$$L = \frac{12\,d^3}{1}$$ . Damit beträgt der Gasleitwert der Kanüle

in etwa $2 \cdot 10^{-2}$ l/sec. Wird für den Gasdruck des Ausgangsmaterials 113 ein Wert von 0,1 mbar angenommen, so ergibt sich für den Gasstrom Q durch die Kanüle in die Bearbeitungskammer 7 ein Wert von $10^{-3}$ mbarl/sec. Wird für das effektive Saugvermögen $S_{eff}$ der die Bearbeitungskammer 7 evakuierenden Turbomolekularpumpe 9 ein Wert von 100 1/sec angenommen, so wird sich in der Bearbeitungskammer 7 ein Endvakuum bzw. ein Partialdruck des Reaktionsgases

$$p_{end} = \frac{Q}{S_{eff}} = 10^{-5}$$ mbar einstellen.

In der unmittelbaren Umgebung des Austrittsendes 59 der Kanüle 57 wird die Dichte des Reaktionsgases allerdings wesentlich höher sein als in weiteren von dem Austrittsende 59 entfernten Bereichen der Bearbeitungskammer. Deshalb ist das Austrittsende 59 mit einem lediglich geringen Abstand von dem zu bearbeitenden Ort des Werkstücks 3 angeordnet, und der auf das Werkstück 3 gerichtete Elektronenstrahl kann dann das Reaktionsgas zu einer effektiven Reaktion mit dem Werkstück anregen.

Um diese Reaktion möglichst präzise zu steuern, ist es somit notwendig, auch die Menge des aus der Kanüle 57 austretenden Reaktionsgases möglichst präzise einzustellen.

Es hat sich gezeigt, dass herkömmliche Lösungen, die zur Einstellung des Gasflusses Dosierventile, wie etwa Nadelventile, einsetzen, nicht zufriedenstellend arbeiten, da ein Dosierverhalten des Nadelventils sich zeitlich ändert und dadurch die auszuführende Materialbearbeitung an dem Werkstück eine nicht zufriedenstellende Reproduzierbarkeit aufweist. Entsprechend ist in dem hier gezeigten Beispiel als Ventil 72 nicht ein Dosierventil sondern ein Zweistellungsventil eingesetzt, welches von einer den Gasfluss im wesentlichen versperrenden Stellung in eine den Gasfluss im wesentlichen vollständig freigebenden Stellung überführbar ist. Zwar bewegt sich der Ventilkörper hierbei kurzzeitig durch Zwischenstellungen, die den Gasfluss mehr oder weniger freigeben, allerdings ist das Ventil nicht dazu ausgelegt, einen Gasfluss fein zu dosieren.

In der völlig geöffneten Stellung des Ventils 72 ist der Gasstrom durch die Kanüle 57 somit im wesentlichen durch den Gasleitwert der Kanüle und den Dampfdruck des Ausgangsmaterials 113 gegeben. Bei gegebener Geometrie der Kanüle 57 liegt auch deren Gasleitwert fest, so dass der Gasdruck des Ausgangsmaterials 113 geändert werden muss, um den Gasstrom durch die Kanüle 57 zu ändern. Hierzu ist an dem Reservoir 111 eine Temperiervorrichtung 115 vorgesehen, wozu an dem Reservoir 111 mehrere Windungen 117 eines Flüssigkeitskreislaufes angebracht sind, welcher von einer Wärme/Kältemaschine 119 getrieben ist. Die Wärme/Kältemaschine 119 stellt die Temperatur der den Flüssigkeitskreislauf durchströmenden Flüssigkeit auf einen Wert ein, der von einer Steuerung 121 vorgegeben wird. Die Steuerung 121 liest weiter ein Signal eines Drucksensors 123 aus, welcher den Gasdruck innerhalb des Reservoirs 111 misst. Da dieser Gasdruck im wesentlichen durch den Dampfdruck des Ausgangsmaterials 113 gegeben ist, wird die Steuerung 121 der Wärme/Kältemaschine 119 eine höhere Temperatur als eine momentane Temperatur vorgeben, um die Temperatur des Ausgangsmaterials 113 zu erhöhen, wenn der von dem Sensor 123 gemessene Druck geringer ist als ein gewünschter Dampfdruck des Ausgangsmaterials 113. Umgekehrt wird die Steuerung 121 der Wärme/Kältemaschine 119 eine geringere Temperatur vorgeben, wenn der von dem Sensor gemessene Druck größer ist als der gewünschte Dampfdruck.

Der Gasleitwert der Kanüle 57 ist hierbei auf das zu verwendende Ausgangsmaterial 113 derart abgestimmt, dass zur Einstellung des gewünschten Dampfdrucks die Temperatur des Ausgangsmaterials 113 niedriger einzustellen ist als die Betriebstemperatur der Vorrichtung bzw. die Raumtemperatur. Zwar ist es möglich, mit der Wärme/Kältemaschine 119 die Temperatur des Ausgangsmaterials 113 auch höher einzustellen als die Betriebs- bzw. Raumtemperatur. Es besteht dann allerdings die Möglichkeit, dass sich das in dem erwärmten Reservoir 111 von der Oberfläche des Ausgangsmaterials 113 abdampfende bzw. sublimierende Reaktionsgas an im Vergleich hierzu kälteren Wandungen der Gaszuführung 55 niederschlägt. Insbesondere im Inneren der Kanüle 57, welche einen definierten Gasleitwert bereitstellen soll, wird ein solcher Niederschlag an Reaktionsgas zu einer Reduzierung des Gasleitwerts und damit zu einer schlechten Reproduzierbarkeit der Ergebnisse führen. Ist allerdings, wie vorangehend beschrieben, die Temperatur des Ausgangsmaterials 113 in dem Reservoir 111 niedriger als die Temperatur der übrigen Wandungen der Gaszuführung 55, so ist eine solche Abscheidung des Reaktionsgases an den Wandungen der Gaszuführung 55 im wesentlichen vermieden.

Die in Figur 2 gezeigte Gaszuführungsanordnung 53 ist dazu ausgelegt, zwei Reaktionsgase auszustoßen, welche durch den Elektronenstrahl zu einer solchen Reaktion miteinander angeregt werden, dass sich Platin-Kohlenstoff-Verbundwerkstoff an dem Werkstück 3 in dem Bereich abscheidet, auf den der Elektronenstrahl gerichtet ist. Hierzu ist in dem in Figur 2 linken Reservoir 111 Wasserstoffperoxid als Feststoff bei einer Temperatur von minus 40°C enthalten. Bei dieser Temperatur beträgt der Dampfdruck von Wasserstoffperoxid 0,05 mbar. Das Wasserstoffperoxid wird durch die in Figur 2 obere Kanüle 57 zum Bearbeitungsort hin ausgestoßen. Diese Kanüle 57 weist einen Innendurchmesser von 0,8 mm und eine Länge von 50 mm auf, womit ihr Gasleitwert $1,6 \cdot 10^{-3}$ l/sec beträgt. Damit strömt bei geöffnetem Ventil 72 Wasserstoffperoxid in einer solchen Menge aus dem Austrittsende 59 aus, dass sich auf dem Werkstück etwa 52 Monolagen Wasserstoffperoxid pro Sekunde abscheiden können.

Das in Figur 2 rechte Reservoir enthält Cyclopentadienyl-Trimethyl-Platin bei einer Temperatur von 20 Grad Celsius, bei der dessen Dampfdruck 0,05 mbar beträgt. Die in Figur 2 untere Kanüle 57, durch die dieses Gas zum Bearbeitungsort strömt, weist einen Innendurchmesser von 1,4 mm und ebenfalls eine Länge von 5 mm auf, so dass deren Leitwert $1,6 \cdot 10^{-3}$ 1/sec beträgt. Unter diesen Bedingungen strömt das Gas Cyclopentadienyl-Trimethyl-Platin in einer solchen Menge aus der Kanüle aus, dass sich auf dem Werkstück eine Abscheidung von etwa 276 Monolagen pro Sekunde ergeben würde.

Bei aus der Gaszuführungsanordnung 53 ausströmenden Reaktionsgasen stellt sich innerhalb der Bearbeitungskammer ein Gasdruck ein, der zu groß ist, um darin die Elektronenquelle 23 zu betreiben. Deshalb ist innerhalb des Strahlrohres 43 (vergleiche Figur 1) eine Druckblende 121 angeordnet, welche einen von dem Elektronenstrahl durchsetzten Innendurchmesser von 1 mm aufweist. Die Druckblende 121 separiert den Vakuumraum des Materialbearbeitungssystems 1 in einen unterhalb der Druckblende 121 angeordneten und die Bearbeitungskammer 7 umfassenden Vakuumraum und einen oberhalb der Druckblende 121 angeordneten Zwischen-Vakuumraum. Der oberhalb der Druckblende 121 angeordnete Vakuumraum ist weiter unterteilt in Teilvakuumräume 125 und 127, welche separat gepumpt sind. Der Zwischen-Vakuumraum 123 ist durch eine separate Turbomolekularpumpe 129 gepumpt und nach unten begrenzt durch die Druckblende 121 sowie nach oben durch eine Druckblende 131 mit einem Innendurchmesser von 500 $\mu$m.

Der Vakuumraum 125 wird durch eine Ionen-Getter-Pumpe 133 gepumpt und ist nach unten durch die Druckblende 131 begrenzt sowie nach oben durch eine weitere Druckblende 135 mit einem Innendurchmesser von 80 $\mu$m. Der oberhalb der Druckblende 135 liegende Vakuumraum 127 wird durch eine weitere Ionen-Getter-Pumpe 137 evakuiert und enthält die Elektronenquelle 23 selbst.

Ein durch einen Antrieb 140 betätigter Verschluss 139 ist vorgesehen, um die Druckblende 131 vollständig zu verschließen. Der Antrieb 140 wird von der Steuerung 37 angesteuert und zwar derart, dass der Verschluss 139 nur dann geöffnet wird, wenn ein von der Steuerung 37 ausgelesener Drucksensor 142 in dem Teilraum 123 einen Druck registriert, der geringer ist als $10^{-3}$ mbar.

Dichtungen 145 sind vorgesehen, um die Polschuhe 29 und 31 gegenüber dem Strahlrohr 43 abzudichten, so dass die Wicklung 32 zur Objektivlinse 27 nicht im Vakuum angeordnet sein muss.

Durch die Separierung des Vakuumraums der Bearbeitungskammer 7 von dem die Elektronenquelle 23 umfassenden Vakuumraum, welcher wiederum in Teilräume 123, 125, 127 unterteilt ist, ist es möglich, das Elektronenmikroskop auch dann zu betreiben, wenn Reaktionsgas in die Bearbeitungskammer 7 geleitet wird. Es ist somit möglich, durch das Elektronenmikroskop 15 einen auf das Werkstück 3 fein fokussierten Elektronenstrahl bereitzustellen, um das Reaktionsgas zur Reaktion mit dem Werkstück 3 an ausgewählten Orten anzuregen.

Ferner ist es möglich, mit dem Elektronenmikroskop 15 elektronenmikroskopische Bilder des Werkstücks 3 aufzunehmen und dadurch den Fortgang der Bearbeitung des Werkstücks zu überprüfen. Die elektronenmikroskopischen Bilder können jedenfalls dann aufgenommen werden, wenn gerade Reaktionsgas nicht in die Nähe des Bearbeitungsortes geführt wird, wobei dann besonders gute Vakuumbedingungen in der Bearbeitungskammer 7 herrschen. Es ist jedoch auch möglich, elektronenmikroskopische Bilder aufzunehmen, wenn Reaktionsgas aus den Kanülen 59 ausströmt. Man wird dann allerdings die elektronenmikroskopischen Bilder mit geringer Intensität des Elektronenstrahls oder mit geringer räumlicher Auflösung aufnehmen, um nicht unnötig Reaktionen des Reaktionsgases mit dem Werkstück auszulösen.

Bei manchen Bearbeitungsbedingungen ist es wünschenswert, in der Bearbeitungskammer einen hohen Gasdruck bereitzustellen, um unerwünschte lokale elektrostatische Aufladungen des Werkstücks 3 zu vermeiden. Die Steuerung 37 schaltet dann das Materialbearbeitungssystem in einen Betriebsmodus um, in dem die die Bearbeitungskammer 7 evakuierende Turbomolekularpumpe 9 ausser Betrieb gesetzt ist. Es wird die Bearbeitungskammer 7 dann lediglich durch eine in der Figur 1 nicht dargestellte Vorpumpe der Turbomolekularpumpe 9 evakuiert, wobei der Gasdruck in der Bearbeitungskammer auf etwa 1 mbar steigen kann.

Nachfolgend werden Variante der vorangehend anhand der Figuren 1 bis 4 erläuterten Beispiele dargestellt. Hierbei sind hinsichtlich ihres Aufbaus und ihrer Funktion einander entsprechende Komponenten mit den gleichen Bezugsziffern wie in den Figuren 1 bis 4, zur Unterscheidung jedoch mit einem zusätzlichen Buchstaben versehen. Es wird hierbei auf die gesamte vorangehende Beschreibung Bezug genommen.

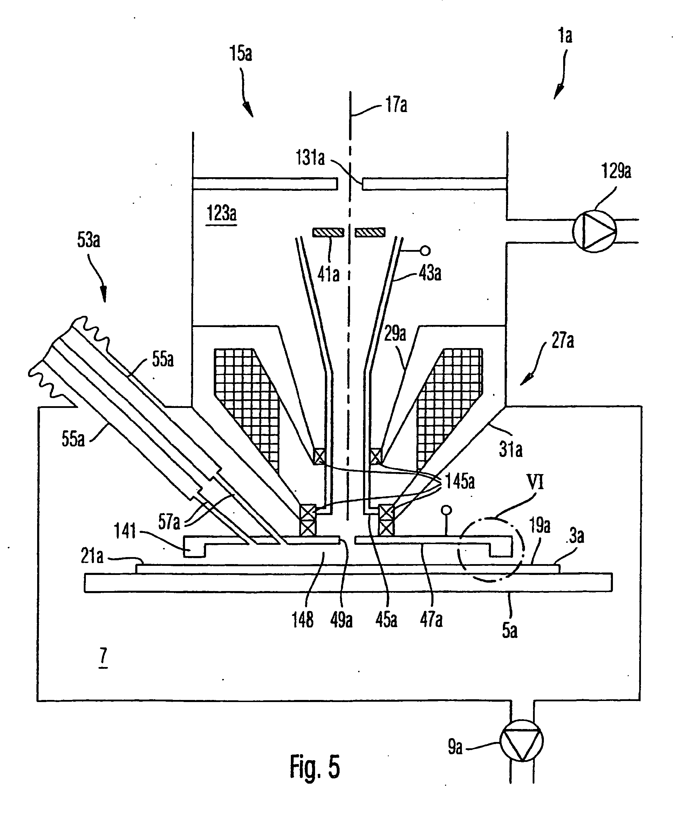

Ein in Figur 5 gezeigtes Materialbearbeitungssystem 1a umfasst wiederum eine Bearbeitungskammer 7a, in der ein Werkstück 3a auf einer Werkstückhalterung 5a derart angeordnet ist, dass eine Oberfläche 21a des Werkstücks 3a in einer Objektebene eines Elektronenmikroskops 15a liegt.

Ferner ist eine Gaszuführungsanordnung 53a vorgesehen, um mehrere Reaktionsgase nahe einem Bearbeitungsort auszustoßen, welcher in einem Bereich um eine Hauptachse 17a des Elektronenmikroskops 15a liegt.

Das Elektronenmikroskop 15a umfasst ebenfalls ein sich nach unten konisch verjüngendes Strahlrohr 43a, welches zum Werkstück 3a hin in einem sich radial erstreckenden Kragen 45a endet. Zwischen dem Kragen 45a und dem Werkstück 3a ist wiederum eine Elektrodenblende 47a angeordnet, welche jedoch im Unterschied zu dem vorangehend erläuterten Biespiel auch als Druckblende zur Separierung von Vakuumräumen dient. Hierzu weist die Elektrodenblende 47a einen Innendurchmesser von 200 $\mu$m auf. Dieser geringe Blendendurchmesser beschränkt zwar das Bildfeld des Elektronenmikroskops, es ergeben sich hierdurch allerdings andere Vorteile.

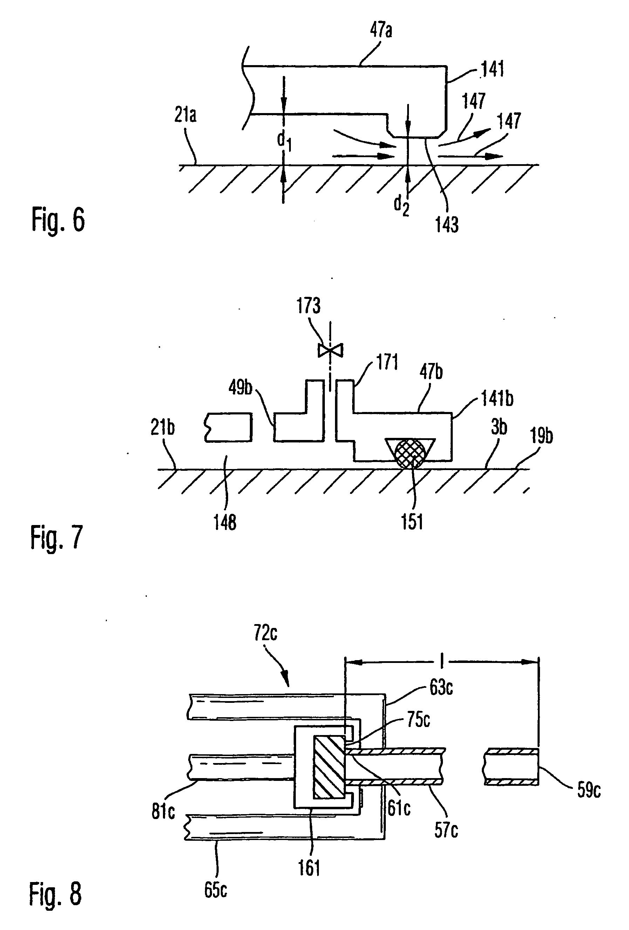

Die Blendenelektrode 47a erstreckt sich parallel zu der Oberfläche des Werkstücks 3a mit einem Abstand $d_1$ von 300 $\mu$m. Die Blendenelektrode 47a trägt ferner einen sich mit Abstand um die Hauptachse 17a des Elektronenmikroskops 15a ringförmig erstreckenden Vorsprung 141, der eine zu der Oberfläche des Werkstücks 3a und damit zu der Objektebene 19a hinweisende Planfläche 143 aufweist. Zwischen der Planfläche 143 und der Probenoberfläche bzw. Objektebene 19a besteht ein Abstand $d_2$ von 75 $\mu$m. Damit ist zwischen der Blendenelektrode 47a und dem Werkstück ein Vakuumteilraum 148 gebildet, in welchem Kanülen 57a der Gaszuführungsanordnung 53a enden. Hierzu durchsetzen die Kanülen 57a die Blendenelektrode 47a von oben. Der Vakuumteilraum 148 ist gegenüber dem übrigen Vakuumraum der Bearbeitungskammer 7a durch den Vorsprung 141 abgedichtet, wobei allerdings durch den Spalt $d_2$ zwischen der Planfläche 143 und der Oberfläche des Werkstücks 3a eine gewisse Leckrate bereitgestellt ist, wie dies durch Pfeile 147 in Figur 6 angedeutet ist.

Durch die Separierung des Vakuumteilraums 148 ist es möglich, zur Bearbeitung des Werkstücks 3a besonders hohe Partialdrücke an Reaktionsgasen bereitzustellen und hierdurch hohe Reaktionsraten zu erzielen. Da der Teilraum 148 im Vergleich zu der Bearbeitungskammer 7a klein ist, ermöglicht dies gleichzeitig einen sparsamen Umgang mit den Reaktionsgasen.

In Figur 7 ist eine Variante der in den Figuren 5 und 6 gezeigten Ausführungsform schematisch dargestellt. Hierbei trägt eine Blendenelektrode 47b an ihrem zu der Objektebene hin axial vorstehenden Vorsprung 141b einen Dichtring 151 aus dem Material "Viton" oder einem anderen geeigneten Elastomermaterial, welcher zur Anlage an dem Werkstück ausgelegt ist. Das Material des Dichtrings 151 ist derart gewählt, dass eine Verlagerung des Werkstücks 3a relativ zu der Blendenelektrode 47b das Werkstück 3b nicht beschädigt.

Der Teilraum 148 kann evakuiert werden, indem die Werkstückhalterung samt dem darauf montierten Werkstück 3b abgesenkt wird, so dass zwischen dem Dichtring 151 und der Oberfläche 21b des Werkstücks 3b ein ausreichender Abstand bereitgestellt ist, um ein Ausströmen des Gases in dem Teilraum 148 zu ermöglichen. Alternativ hierzu ist es auch möglich, an der Blendenelektrode 47b einen Saugstutzen 171 anzubringen, der sich von der Blendenelektrode 47 in Richtung von der Objektebene 19b weg erstreckt und durch ein schaltbares Ventil 173 verschlossen ist, welches in geöffnetem Zustand den Teilraum 148 mit dem Vakuumraum der Bearbeitungskammer verbindet und in seinem geschlossenen Zustand diese beiden Vakuumräume voneinander separiert.

Figur 8 zeigt eine Variante eines Ventils einer Gaszuführungsanordnung. Im Unterschied zu dem in Figur 3 gezeigten Ventil dichtet ein Ventilkörper 75c eines in Figur 8 gezeigten Ventils 72c unmittelbar gegen ein Eintrittsende 61c einer Kanüle 57c ab. Hierzu ist der aus einem Elastomermaterial gefertigte Ventilkörper 75c in eine Halterung 161 eingebettet, welche mit einer Stange 81c zur Betätigung des Ventils 72c verbunden ist. Die Kanüle 57c steht mit ihrem Eintrittsende 61c durch eine Stirnwand 63c eines Rohres 65c ins Innere des Rohres 65c vor, so dass eine Stirnseite des Eintrittsendes 61c der Kanüle 57c in direktem Kontakt mit dem Ventilkörper 75c kommen kann, um einen Gasfluss aus dem Inneren des Rohres 65c in die Kanüle 57c zu verschließen.

Bei dieser Ausführung des Ventils 72c weist eine Größe $c = \dfrac{V}{A \cdot l}$ einen Wert von 1,0 auf, wobei

A   ein Innenquerschnitt der Kanüle 57c,

l   ein Abstand zwischen dem Ventilkörper 75c und dem Austrittsende 59c der Kanüle 57c und

V   ein Volumen zwischen dem Austrittsende 59c und dem Ventilkörper 75c

ist. Es ist mit dieser Ausführungsform ein nach dem Verschließen des Ventils 72c zu entleerendes Restgasvolumen auf ein Minimum reduziert, so dass eine Reaktion des Reaktionsgases mit dem Werkstück nach Verschließen des Ventils 72c weitestgehend reduziert ist.

Figur 9 zeigt eine Variante der in Figur 2 dargestellten Gasversorgungsanordnung, wobei hier die Gaszuführung in das Rohr, an dem die Kanüle gehalten ist, abgewandelt ist.

Bei einer in Figur 9 gezeigten Gaszuführungsanordnung 53c wird das zuzuführende Reaktionsgas über einen Stutzen 89c einem Rohr 65c zugeführt, in welchem eine Stange 81c zur Betätigung eines in Figur 9 nicht gezeigten Ventilkörpers gehalten ist. Das Rohr 65c durchsetzt einen Flansch 95c und ist an diesem mechanisch festgehalten.

Ein Ende des Rohres 65 ist mit einem Faltenbalg 103c vakuumdicht verbunden, und dieser schließt über ein Rohrzwischenstück 181 vakuumdicht an einen Querträger 183 an, wobei die Verbindung zwischen dem Rohrzwischenstück 181 und dem Querträger 183 beispielsweise durch Schweißen erfolgen kann. An dem Querträger 183 ist innerhalb des Rohres 65c koaxial zu diesem die dem Ventilkörper betätigende Stange 81c ebenfalls durch Schweißen festgemacht. Der Querträger 183 ist an einem Zylinder 85c einer Kolbenzylindereinheit befestigt, deren Kolben 83c über eine Stange 106c mit dem Flansch 95c gekoppelt ist. Durch Zuführung von Druckluft über Anschlüsse 87c an die Kolbenzylindereinheit kann der Kolben 83c innerhalb des Zylinders 85c verlagert werden, was gleichfalls zu einer Verlagerung der Stange 81c innerhalb des Rohrs 81c führt, da der Faltenbalg 113 komprimierbar ist.

Auf der von dem Rohrzwischenstück 181 abgewandten Seite des Querträgers 183 ist der Anschluss 89c für das zuzuführende Gas ebenfalls vakuumdicht angeschlossen. Der Querträger ist von Öffnungen 185 durchsetzt, so dass das Gas von dem Anschlussstutzen 89c in das Innere des Rohres 85c übertreten kann.

Bei der im Zusammenhang mit Figur 2 beschriebenen Temperierungsvorrichtung sind eine Mehrzahl von Windungen von einer Kühlflüssigkeit oder Wärmeflüssigkeit durchströmt, und diese übertragen die Kälte bzw. Wärme direkt auf das Innere des Reservoirs. Es ist jedoch auch möglich, hier beispielsweise Peltier-Elemente zwischenzuschalten, um noch tiefere Temperaturen innerhalb des Reservoirs zu erreichen.

Ein Einsatz des vorangehend beschriebenen Materialbearbeitungssystems kann wie folgt erfolgen. Diese wird hierbei für die Bearbeitung eines Werkstücks, insbesondere die Reparatur einer Photomaske, vorgesehen. Das Verfahren ist dabei vorzugsweise mittels eines Steuerrechners zum Steuern der Bestandteile des Materialbearbeitungssystems voll automatisiert. Eine Defekte aufweisende Photomaske wird zunächst mittels herkömmlicher optischer oder korpuskularstrahloptischer Geräte, beispielsweise eines AIMS-Gerätes, abgetastet, um so die Koordinaten der Maskendefekte zu ermitteln. Die diese Koordinaten enthaltenden Daten werden in den Steuerrechner eingegeben und mittels Eingangs-Übersetzern des Steuerrechners in ein für das Materialbearbeitungssystem geeignetes Datenformat im Steurrechner konvertiert. Die zu bearbeitende Photomaske wird manuell, halbautomatisch oder automatisch in die Bearbeitungskammer des Materialbearbeitungssystems eingeführt. Besonders bevorzugt wird die zu bearbeitende Photomaske in einem für den Maskentransport üblicherweise verwendeten Behältnis, wie zum Beispiel einer sogenannten "SMIF Box", mittels eines rechnergesteurten Maskenladers an eine Eingangsstation des Bearbeitungssystem herangebracht, in die Eingangstation eingeführt und aus dem Behältnis entfernt, um dort entweder gleich in die Bearbeitungskammer des Materialbearbeitungssystems überführt oder zur Weiterverarbeitung in einer Ausgangsstation des Materialbearbeitungssystems abgelegt zu werden. Befindet sich die Photomaske in der Bearbeitungskammer, können die Defektstellen der Photomaske anhand der Defektkoordinaten durch Verschieben der die Photomaske halternden Werkstückhalterung aufgesucht, d.h. in den Bereich des Elektronenstrahls gebracht werden, wobei die Position des Werkstücks relativ zu dem Elektronenmikroskop mit Hilfe der Laserinterferometer kontrolliert wird. Mit dem Elektronenstrahl wird die Oberfläche des Werkstücks dann abgetastet, um ein hochaufgelöstes Bild der gerade zu bearbeitenden Defektstelle zu gewinnen. Weiterhin kann mit Hilfe des energiedispersiven Röntgendetektionssystems (EDX-System) eine Charakterisierung der Materialien, insbesondere eine Elementanalyse, an der Oberfläche der Defektstellen der Photomaske erfolgen. Abbildung und/oder EDX-Analyse können dabei manuell, halb- oder vollautomatisch durchgeführt werden. Anhand der durch elektronenoptische Abbildung und/oder EDX-Analyse ermittelten Daten und Vergleich dieser Daten mit im Steuerrechner verfügbaren Soll-Daten wird eine zu reparierende Defekt-Größe von dem Steuerrechner ermittelt. Die zur Reparatur der Defekt-Größe notwendigen Schritte werden von dem Steuerrechner durch Zuordnung der Defektgröße zu einem in dem Steuerrechner gespeicherten Reparaturvorgang und Reparaturparametern ermittelt. Die zur Reparatur der Defektstelle notwendigen Schritte und Parameter des Reparaturvorgangs, insbesondere Auswahl der zuzuführenden Gase, zeitliche Steuerung der Gaszufur, Richten des Elektronenstrahls mit einem vorbestimmten Energiewert auf die zu bearbeitende Defektstelle der Photomaske, werden von dem Steuerrechner vorzugsweise automatisiert durchgeführt. Nach Beenden der Elektronenstrahlinduzierten chemischen Reaktion an der Defektstelle der Photomaske wird die bearbeitete Defektstelle erneut elektronenoptisch abgetastet und abgebildet. Mittels des Steuerrechners wird die erhaltene Abbildung mit der Soll-Abbildung verglichen und, bei einem vorbestimmten Grad an Abweichung der Abbildungen, weitere Reparaturschritte durchgeführt oder aber die Photomaskenreparatur beendet, woraufhin die reparierte Photomaske als Endprodukt des Verfahrens zur weiteren Verwendung bereitgestellt wird.

Eine bevorzugte Anwendung der des vorangehend beschriebenen Systems und Verfahrens liegt in der Bearbeitung und Reparatur von Photomasken für Lithographieverfahren. Wie bereits erwähnt, kann die Photomaske eine phasenschiebende Maske sein. Es ist jedoch auch daran gedacht, binäre Masken zu bearbeiten, bei denen die Strukturen beispielsweise durch Chrom enthaltende Bereiche gebildet sind, welche auf einem Glassubstrat oder $SiO_2$-Substrat abgeschieden sind. Diese Masken können hierbei auch sog. "Proximity-Korrekturen" aufweisen, d.h. besonders kleine Strukturen, welche mit Hilfe des Elektronenmikroskops auflösbar sind.

Allerdings können auch andere Werkstücke mit dem System bearbeitet werden, wie etwa mikro-mechanische Bauteile oder ähnliches.

Es ist ebenfalls daran gedacht, die vorangehend erläuterte Gaszuführung nicht nur in Kombination mit einem Elektronenmikroskop einzusetzen, sondern diese auch in Kombination mit anderen Energiestrahlen, wie beispielsweise Ionenstrahlen oder Photonenstrahlen, zu verwenden.

Ferner kann die vorangehend beschriebene Technik, bei der das Reservoir für das Ausgangsmaterial gekühlt ist, auch bei Gasversorgungen eingesetzt werden, welche nicht mit einer Kanüle arbeiten oder welche nicht ein Zweistellungsventil, sondern beispielsweise ein Dosierventil, aufweisen.

**Patentansprüche**

1. Materialbearbeitungssystem, umfassend:

   - eine Bearbeitungskammer (7),
   - eine Werkstückhalterung (5) zum Haltern eines zu bearbeitenden Werkstücks (3) in der Bearbeitungskammer (7) derart, dass ein Oberflächenbereich des Werkstücks (3) in einer Objektebene (19) anordenbar ist,
   - ein Elektronenmikroskop (15) mit

      - einer Elektronenquelle (23) zur Erzeugung eines Elektronenstrahls,
      - wenigstens eine Fokussierlinse (27) zum Fokussieren des Elektronenstrahls auf der Objektebene (19) und
      - wenigstens einen Elektronendetektor (41, 39) zum Detektieren von aus einem Bereich der Objektebene (19) austretenden Elektronen;

      - eine Gaszuführungsanordnung (53) zur Zuführung

   wenigstens ein Reaktionsgas , welches mittels des fokussierten Elektronenstrahls zu einer Reaktion mit dem Werkstück (3) anregbar ist, wobei das Elektronenmikroskop (15) wenigstens ein Paar von Druckblenden (121, 131; 47a) mit jeweils einer von dem Elektronenstrahl durchsetzten Öffnung (49) umfasst, wobei eine erste der beiden Druckblenden (121; 47a) einen Vakuumraum der Bearbeitungskammer (7) von einem Zwischen-Vakuumraum (123) teilweise separiert und eine zweite der beiden Druckblenden (131) den Zwischen-Vakuumraum (123) von einem die Elektronenquelle (23) umfassenden Vakuumraum (123, 125, 127) teilweise separiert, wobei eine Vakuumpumpanordnung (129) einen ersten Anschluss zum Zwischen-Vakuumraum (123) aufweist, und wobei ein erster Elektronendetektor (41) in dem Zwischen-Vakuumraum (123) angeordnet ist, wobei eine der Objektebene (19a) am nächsten angeordnete Komponente (141) des Elektronenmikroskops eine den Elektronenstrahl ringförmig umschließende im wesentlichen plane der Objektebene (19a) zuweisende Endfläche (143) aufweist, und wobei die Endfläche (143) der der Objektebene (19a) am nächsten angeordneten Komponente (141) des Elektronenmikroskops (15a) dazu ausgebildet ist, von der Objektebene (19a) einen Abstand ($d_2$) von weniger als 100 $\mu$m, insbesondere weniger als 50 $\mu$m, aufzuweisen.

2. Materialbearbeitungssystem nach Anspruch 1, wobei eine der Objektebene (19) nächstliegende Fokussierlinse (27) des Elektronenmikroskops (15) zwischen dem ersten Detektor (41) und der Objektebene (19) angeordnet ist.

3. Materialbearbeitungssystem nach Anspruch 1 oder 2, wobei dem ersten Anschluss eine separate Turbomolekularpumpe (129) zum Abpumpen des Zwischen-Vakuumraums (123) zugeordnet ist.

4. Materialbearbeitungssystem nach einem der Ansprüche 1 bis 3, wobei die der Objektebene (19b) am nächsten angeordnete Komponente (141b) des Elektronenmikroskops als Dichtung (151) zur Anlage an dem Werkstück (3b) ausgebildet ist.

5. Materialbearbeitungssystem nach Anspruch 4, wobei die Werkstückhalterung dazu ausgebildet ist, das Werkstück von der Anlage an der als Dichtung ausgebildeten Komponente zu entfernen.

6. Materialbearbeitungssystem nach einem der Ansprüche 1 bis 5, wobei die Druckblende (47a) zwischen der der Objektebene (19a) nächstliegenden Fokussierlinse (27a) des Elektronenmikroskops (15a) und der Objektebene (19a) angeordnet ist.

7. Materialbearbeitungssystem nach einem der Ansprüche 1 bis 6, wobei ein zweiter Elektronendetektor (39) in der Bearbeitungskammer (7) angeordnet ist.

8. Materialbearbeitungssystem nach einem der Ansprüche 1 bis 7, wobei die Vakuumpumpanordnung einen zweiten Anschluss (9) zu dem Vakuumraum der Bearbeitungskammer (7) aufweist.

9. Materialbearbeitungssystem nach Anspruch 8, ferner umfassend eine Steuerung (37) zum Umschalten der Vakuumpumpanordnung (9, 129) zwischen einem ersten und einem zweiten Betriebsmodus, wobei in dem ersten Betriebsmodus die Bearbeitungskammer (7) über den zweiten Anschluss (9) stärker evakuierbar ist als in dem zweiten Betriebsmodus.

**10.** Materialbearbeitungssystem nach Anspruch 9, wobei dem zweiten Anschluss eine separate Turbomolekularpumpe (9) zugeordnet ist, wobei die Steuerung (37) und die separate Turbomolekularpumpe (9) konfiguriert sind, dass die separate Turbomolekularpumpte (9) in dem zweiten Betriebsmodus ausser Betrieb ist.

**11.** Materialbearbeitungssystem nach Anspruch 9 oder 10, wobei das Materialbearbeitungssystem konfiguriert ist, dass ein Gasdruck in der Bearbeitungskammer (7) in dem ersten Betriebsmodus kleiner als etwa 0.05 mbar und in dem zweiten Betriebsmodus größer als 0,1 mbar ist.

**12.** Materialbearbeitungssystem nach einem der Ansprüche 1 bis 11, ferner umfassend energieauflösenden Photonen-Detektor (51), insbesondere Röntgen-Detektor, zur Detektion von aus dem Werkstück (3) aufgrund einer Wechselwirkung mit dem Elektronenstrahl austretenden Photonen.

**13.** Verfahren zum Bearbeiten eines Werkstücks, umfassend:

- Aufnehmen eines elektronenmikroskopischen Bildes eines Bereichs des Werkstücks durch Richten eines Elektronenstrahls an eine Vielzahl von Orten innerhalb des Bereichs und Registrieren von aus dem Werkstück austretenden Sekundärelektronen in Abhängigkeit von den Orten, auf die der Elektronenstrahl gerichtet ist,
- Festlegen wenigstens eines Ortes innerhalb des Bereichs des Werkstücks, an dem Material des Werkstücks abzutragen ist oder an dem Material an dem Werkstück abzuscheiden ist,
- Zuführen wenigstens eines Reaktionsgases zu dem Bereich des Werkstücks,
- Richten des Elektronenstrahls des auf den wenigstens einen bestimmten Ort des Werkstücks, um das wenigstens eine Reaktionsgas zu einer Reaktion mit dem Werkstück anzuregen, wobei das Verfahren unter Einsatz des Materialbearbeitungssystems nach einem der Ansprüche 1 bis 12 durchgeführt wird.

**14.** Verfahren nach Anspruch 13, wobei das Aufnehmen des elektronenmikroskopischen Bildes nach der Anregung der Reaktion erfolgt und in Abhängigkeit von dem aufgenommenen Bild wenigstens ein weiterer Ort innerhalb des Bereichs des Werkstücks festgelegt wird, an dem Material von dem Werkstück abzutragen oder an diesem abzuscheiden ist.

**15.** Verfahren nach einem der Ansprüche 13 bis 14, wobei das Werkstück eine Maske zur Verwendung in einem Lithographieverfahren, insbesondere eine Photomaske und weiter bevorzugt eine Phasenmaske ist.

## Claims

**1.** A material processing system, comprising:

- a processing chamber (7),
- a work piece mount (5) configured for mounting a work piece (3) to be processed in the processing chamber (7) such that a surface portion of the work piece (3) is positionable in an object plane (19),
- an electron microscope (15), having an electron source (23) for generating an electron beam;
at least one focusing lens (27) for focusing the electron beam in an object plane (19), and
at least one electron detector (41, 39) for detecting electrons emanating from a portion of the object plane (19);
- a gas supply arrangement (53) for supplying at least one reactive gas which can be caused to react with the work piece (3) by means of the focused electron beam,

wherein the electron microscope (15) comprises at least a pair of pressure diaphragms (121, 131; 47a), each having an aperture (49) for the electron beam to pass therethrough, wherein a first one (121; 47a) of said two pressure diaphragms partially separates a vacuum section of the processing chamber (7) from an intermediate vacuum section (123) and a second one (131) of said two pressure diaphragms partially separates the intermediate vacuum section (123) from a vacuum section (123, 125, 127) accommodating the electron source (23), wherein a vacuum pumping arrangement (129) has a first port to the intermediate vacuum section (23), and wherein a first electron detector (41) is accommodated in the intermediate vacuum section (123),
wherein a component (141) of the electron microscope disposed closest to the object plane (19a) has a substantially ring-shaped planar end face (143) oriented towards the object plane (19a), and
wherein the end face (143) of the component (141) of the electron microscope (15a) disposed closest to the object plane (19a) is configured to be spaced apart from the object plane (19a) by a distance ($d_2$) of less than 100 $\mu$m, in particular, less than 50 $\mu$m.

**2.** The material processing system according to claim 1, wherein a focusing lens (27) of the electron microscope (15a) disposed closest to the object plane (19) is disposed between the first detector (41) and the object plane (19).

**3.** The material processing system according to claim 1 or 2, wherein a separate turbo molecular pump (129) for evacuating the intermediate vacuum section (123) is allocated to the first port.

**4.** The material processing system according to one of claims 1 to 3, wherein the component (141b) of the electron microscope disposed closest to the object plane (19b) is configured as a sealing (151) for abutment against the work piece (3b).

**5.** The material processing system according to claim 4, wherein the work piece mount is configured to remove the work piece from the abutment against the component configured as sealing.

**6.** The material processing system according to one of claims 1 to 5, wherein the pressure diaphragm (47a) is disposed between the focusing lens (27a) of the electron microscope (15a) disposed closest to the object plane (19a) and the object plane (19a).

**7.** The material processing system according to one of claims 1 to 6, wherein a second electron detector (39) is disposed in the processing chamber (7).

**8.** The material processing system according to one of claims 1 to 7, wherein the vacuum pumping arrangement comprises a second port (9) to the vacuum section of the processing chamber (7).

**9.** The material processing system according to claim 8, further comprising a controller (37) for switching the vacuum pumping arrangement (9, 129) between a first operational mode and a second operational mode, wherein in the first operational mode the processing chamber (7) is evacuatable via the second port (9) to a higher level than in the second operational mode.

**10.** The material processing system according to claim 9, wherein a separate turbo molecular pump (9) is allocated to the second port, the controller (37) and separate turbo molecular pump (9) being configured such that the separate turbo molecular pump (9) is out of operation in the second operational mode.

**11.** The material processing system according to claim 9 or claim 10, wherein the material processing system is configured such that a gas pressure in the processing chamber (7) is less than about 0.05 mbar in the first operational mode and higher than 0.1 mbar in the second operational mode.

**12.** The material processing system according to one of claims 1 to 11, further comprising an energy-sensitive photon detector (51), in particular an X-ray detector for detecting photons emanating from the work piece (3) as a result of an interaction with the electron beam.

**13.** A method for processing a work piece, comprising:

- acquiring an electron-microscopical image of a portion of the work piece by directing an electron beam to a plurality of locations within said portion and detecting secondary electrons emanating from the work piece in dependency of the locations onto which the electron beam is directed,
- determining at least one location within said portion of the work piece where material is to be removed from the workpiece or deposited onto the work piece,
- supplying at least one reactive gas to said portion of the work piece,
- directing an electron beam onto the at least one determined location of the work piece in order to excite the at least one reactive gas to react with the work piece, said method being performed by using the material processing system according to one of claims 1 to 12.

**14.** The method according to claim 13, wherein acquiring the electron-microscopical image is performed after the reaction has been excited and, in dependency of the acquired image, at least one further location is determined within said portion of the work piece where material is to be removed from the work piece or deposited onto the work piece.

**15.** The method according to one of claims 13 to 14, wherein the work piece is a mask for use in a lithographic process, in particular a photo mask and, further preferred, a phase mask.

**Revendications**

**1.** Système de traitement de matériau, comprenant :

- une chambre de traitement (7),
- une fixation de pièce à usiner (5) pour fixer une pièce à usiner (3) à traiter dans la chambre de traitement (7), de telle sorte qu'une zone de surface de la pièce à usiner (3) peut être disposée dans un plan objet (19),
- un microscope électronique (15) avec

- une source d'électrons (23) pour générer un faisceau d'électrons,
- au moins une lentille de focalisation (27) pour concentrer le faisceau d'électrons sur le plan objet (19) et
- au moins un détecteur d'électrons (41, 39) pour la détection d'électrons sortant d'une zone du plan objet (19) ;

- un agencement d'alimentation en gaz (53) pour amener au moins un gaz réactif, pouvant être mis en réaction avec la pièce à usiner (3) au moyen du faisceau d'électrons focalisé,

dans lequel, le microscope électronique (15) comporte au moins une paire d'obturateurs à pression (121, 131 ; 47a) avec chacun une ouverture (49) traversée par le faisceau d'électrons, l'un des deux obturateurs (121 ; 47a) séparant en partie un espace à vide de la chambre de traitement (7) d'un espace à vide intermédiaire (123) et un second des deux obturateurs (131) séparant en partie l'espace à vide intermédiaire (123) d'un espace à vide (123, 125, 127) qui contient l'émetteur électronique (23), un agencement de pompe à vide (129) présentant un premier raccord avec l'espace à vide intermédiaire (123), et un premier détecteur d'électrons (41) étant disposé dans l'espace à vide intermédiaire (123),

dans lequel un composante (141) du microscope électronique, le plus proche du plan objet (19a), présente une surface d'extrémité (143), qui entoure en forme d'anneau le faisceau d'électrons et est orientée de façon essentiellement plane sur le plan objet (19a), et

dans lequel la surface d'extrémité (143) du composant (141) du microscope électronique (15a) la plus proche du plan objet (19a) est réalisée pour présenter un écartement ($d_2$) de moins de 100 $\mu$m, en particulier de moins de 50 $\mu$m, par rapport au plan objet (19a).

2. Système de traitement de matériau suivant la revendication 1, dans lequel une lentille de focalisation (27) du microscope électronique (15) la plus proche du plan objet (19) est disposée entre le premier détecteur (41) et le plan objet (19).

3. Système de traitement de matériau suivant l'une des revendications 1 et 2, dans lequel une pompe turbomoléculaire séparée (129) est associée au premier raccord pour pomper l'espace à vide intermédiaire (123).

4. Système de traitement de matériau suivant l'une des revendications 1 à 3, dans lequel le composant (141b) du microscope électronique le plus proche du plan objet (19b) est configuré sous forme de joint (151) pour placement sur la pièce à usiner (3b).

5. Système de traitement de matériau suivant la revendication 4, dans lequel la fixation de pièce à usiner est réalisée pour écarter la pièce à usiner du contact sur le composant configuré sous forme de joint.

6. Système de traitement de matériau suivant l'une des revendications 1 à 5, dans lequel l'obturateur à pression (47a) est disposé entre la lentille de focalisation (27a) du microscope électronique (15a) la plus proche du plan objet (19a) et le plan objet (19a).

7. Système de traitement de matériau suivant l'une des revendications 1 à 6, dans lequel un second détecteur d'électrons (39) est disposé dans la chambre de traitement (7).

8. Système de traitement de matériau suivant l'une des revendications 1 à 7, dans lequel l'agencement de pompe à vide présente un second raccord (9) à l'espace à vide de la chambre de traitement (7).

9. Système de traitement de matériau suivant la revendication 8, comprenant en outre une commande (37) pour la commutation de l'agencement de pompe à vide (9, 129) entre un premier et un second mode de fonctionnement, la chambre de traitement (7) pouvant être soumise à un vide plus intense dans le premier mode de fonctionnement que dans le second mode de fonctionnement, par l'intermédiaire du second raccord (9).

10. Système de traitement de matériau suivant la revendication 9, dans lequel une pompe turbomoléculaire séparée (9) est associée au second raccord, la commande (37) et la pompe turbomoléculaire séparée (9) étant configurées de sorte que la pompe turbomoléculaire séparée (9) est hors service dans le second mode de fonctionnement.

11. Système de traitement de matériau suivant l'une des revendications 9 et 10, dans lequel le système de traitement de matériau est configuré de sorte qu'une pression de gaz dans la chambre de traitement (7) est inférieure à environ 0,05 mbar dans le premier mode de fonctionnement et supérieure à 0,1 mbar dans le second mode de fonctionnement.

12. Système de traitement de matériau suivant l'une des revendications 1 à 11, comprenant en outre un détecteur de photons (51) à détection d'énergie, en particulier un détecteur à rayons X, pour la détection de photons sortant de la pièce à usiner (3) dus à une interaction avec le faisceau d'électrons.

13. Procédé de traitement d'une pièce à usiner, comprenant :

    - la prise de vue d'une image au microscope électronique d'une zone de la pièce à usiner par direction d'un faisceau d'électrons sur une pluralité d'endroits à l'intérieur de la zone et enregistrement d'électrons secondaires sortant de la pièce à usiner en fonction des endroits sur lesquels est dirigé le faisceau d'électrons,
    - détermination d'au moins un endroit à l'intérieur de la zone de la pièce à usiner auquel du matériau de la pièce à usiner doit être enlevé ou auquel du matériau doit être séparé de la pièce à usiner,

- amenée d'au moins un gaz réactif en direction de la zone de la pièce à usiner,

- direction du faisceau d'électrons sur l'au moins un endroit déterminé de la pièce à usiner, pour mettre en réaction l'au moins un gaz réactif avec la pièce à usiner, le procédé étant mis en oeuvre en utilisant le système de traitement de matériau suivant l'une des revendications 1 à 12.

14. Procédé suivant la revendication 13, dans lequel la prise de vue de l'image au microscope électronique s'effectue après l'activation de la réaction et dans lequel au moins un autre endroit à l'intérieur de la zone de la pièce à usiner est défini en fonction de l'image enregistrée, endroit auquel du matériau doit être enlevé de la pièce à usiner ou doit être séparé de cette dernière.

15. Procédé suivant l'une des revendications 13 à 14, dans lequel la pièce à usiner est un masque pour l'utilisation dans un procédé lithographique, en particulier un photomasque et d'une autre façon préférentielle un masque à phases.

Fig. 1

Fig. 2

**Fig. 3**

**Fig. 4**

**Fig. 9**

Fig. 5

**Fig. 6**

**Fig. 7**

**Fig. 8**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5055696 A
- US 5148024 A
- US 5435850 A
- EP 0106510 A
- WO 0103145 A
- US 6042738 A
- US 5683547 A